# EUROPÄISCHE PATENTSCHRIFT

(11) **EP 3 105 770 B1**
(45) Veröffentlichungstag und Bekanntmachung des Hinweises auf die Patenterteilung: **04.09.2019**
(21) Anmeldenummer: 15704009.8
(22) Anmeldetag: 12.02.2015
(51) Int. Cl.: H01H 57/00, H01H 59/00, H01L 41/09, F16K 99/00, H01H 49/00

(54) **MIKRO-ELEKTRO-MECHANISCHES SYSTEM UND VERFAHREN ZUM HERSTELLEN DESSELBEN**
MICRO-ELECTRO-MECHANICAL SYSTEM
SYSTÈME MICRO-ÉLECTROMÉCANIQUE ET SON PROCÉDÉ DE FABRICATION

(30) Priorität: 14.02.2014 DE 102014202763
(43) Veröffentlichungstag der Anmeldung: 21.12.2016
(73) Patentinhaber: Fraunhofer-Gesellschaft zur Förderung der angewandten Forschung e.V., 80686 München (DE)
(72) Erfinder: LISEC, Thomas, 25524 Itzehoe (DE); STOPPEL, Fabian, 25524 Itzehoe (DE)
(74) Vertreter: Schenk, Markus
(86) Internationale Anmeldenummer: PCT/EP2015/052983
(87) Internationale Veröffentlichungsnummer: WO 2015/121358

(56) Entgegenhaltungen:
- EP-A1- 1 527 465
- CN-A- 102 297 690
- GB-A- 2 353 410
- US-A- 4 893 048

## Beschreibung

Die vorliegende Erfindung bezieht sich auf ein Mikro-Elektro-Mechanisches System (MEMS) mit einer auslenkbaren Aktuatorplatte und ein Verfahren zum Herstellen desselben. Die Erfindung bezieht sich ferner auf eine elektrische Schaltung und auf eine Vorrichtung zum Transport eines Fluids. Die Erfindung bezieht sich ferner auf piezoelektrische Aktuatoren für MEMS-Anwendungen.

Mikromechanische (MEMS) Schalter könnten eine bedeutende Rolle in zukünftigen Kommunikationssystemen spielen. Von Interesse sind insbesondere ohmsche Schalter, da sie in einem weiten Frequenzbereich von DC bis einigen 10 GHz einsetzbar sind. Es gibt jedoch nur wenige kommerzielle Anwendungen in Nischenmärkten, wie der Hochfrequenz-Messtechnik oder im Militärischen. Allen gemeinsam ist, dass sie nahezu leistungslos geschaltet werden müssen (cold switching), um eine hohe Lebensdauer zu erreichen. Selbst unter geringer Last kommt es aufgrund von Entladungen (arcing) zu Erosionseffekten an den Kontaktflächen bis hin zum Verschmelzen derselben (cold welding). Weiche Metalle wie Gold neigen besonders stark zum Verschmelzen, benötigen jedoch nur geringe Kräfte (< 50 µN), um einen Kontaktwiderstand kleiner 1 Ω zu erzielen. Harte Metalle wie Platin (Pt) oder Ruthenium (Ru) sind widerstandsfähiger, erfordern jedoch höhere Kräfte (> 100 µN für 2-3 Ω Kontaktwiderstand). Hohe Kontaktkräfte bis zu 1 mN werden mit elektrostatischen Antrieben erreicht, allerdings auf Kosten hoher Spannungen (50-150 V). In letzter Zeit werden zunehmend piezoelektrische Antriebe untersucht. Diese können erhebliche Kräfte bei wesentlich geringeren Spannungen generieren, insbesondere auf Basis von Blei(P)-Zirkonat(Z)-Titanat(T) - PZT. Die von den bisher beschriebenen Bauelementen erreichten Kräfte sind jedoch vergleichsweise gering.

Piezoelektrisch betätigte ohmsche Schalter können als Aktuatoren mit einseitig fest eingespanntem Balkenelement ausgeführt werden, an dessen beweglichem Ende sich ein Kontakt befindet. Die Balkenstruktur besteht aus einer passiven Schicht mit dem (aktiven) piezoelektrischen Material darauf (inklusive Elektroden). Wird an letzteres eine Spannung angelegt, dehnt es sich lateral aus oder kontrahiert, je nach Polarität der angelegten Spannung, und der Balken verwölbt sich. Diesbezüglich sei auf die Dokumente [1] und [2] sowie Dokument GB 2353410 verwiesen.

In MEMS-Bauelementen mit elektrostatischem Antrieb sind solche Balkenstrukturen weit verbreitet, da sie gut mit diesem Antriebsprinzip harmonieren. Im einfachsten Fall wird ein freistehender, metallischer Balken durch Anlegen einer Spannung gegen eine fixe Elektrodenfläche gezogen. Die dabei entstehende Kraft kann auf einen Kontakt am Balkenende übertragen werden. Piezoelektrische Balkenaktuatoren bilden hingegen einen Stack aus einer passiven Schicht und dem piezoelektrischen Material (aktive Schicht). Aufgrund der Ausdehnung oder Kontraktion der aktiven Schicht in der Balkenebene kann analog zum thermomechanischen Effekt eine Verwölbung der Aktuatorstruktur erreicht werden. Dabei wird die generierte Kraft nur unvollständig auf den Kontakt transferiert.

Ansätze, wie sie beispielsweise aus der US 2002/0074901 bekannt sind, versuchen über eine laterale Unterbrechung der Balkenelemente eine Kraft der jeweiligen Balkenelemente zu erhöhen und/oder Auslenkungen mit geringerem Platzbedarf zu erzielen. Jedoch erfordert dies eine komplizierte Ansteuerung der einzelnen Balkenelemente.

Wünschenswert wäre demnach ein Konzept zum Herstellen oder Lösen eines mechanischen Kontakts, das hohe Kontaktkräfte und eine einfache Ansteuerung ermöglicht.

Die Aufgabe der vorliegenden Erfindung besteht deshalb darin, eine Vorrichtung zu schaffen, die einen herstellbaren und lösbaren mechanischen Kontakt mit hohen mechanischen Kontaktkräften ermöglicht und die einfach ansteuerbar ist.

Diese Aufgabe wird durch den Gegenstand der unabhängigen Patentansprüche gelöst.

Der Kerngedanke der vorliegenden Erfindung besteht darin, erkannt zu haben, dass obige Aufgabe wie z. B. eine Erhöhung mechanischer Kontaktkräfte und/oder eine Vereinfachung der Ansteuerung dadurch erreicht werden kann, dass eine Fläche piezoaktiver Materialien vergrößert und ein Abmessungsverhältnis, etwa zwischen einer Länge und einer Breite des Aktuators, verkleinert wird und dass ferner eine auslenkbare Aktuatorplatte, die in einem ihrer Betriebszustände eine Hohlwölbung entlang zweier linear unabhängiger Raumrichtungen ausführt, die Kontaktkräfte weiter erhöht, so dass Querkontraktionen in der piezoelektrischen Funktionsfläche nutzbar sind.

Durch Umsetzung der Querkontraktionen der piezoelektrischen Funktionsfläche in eine Hohlwölbung zusätzlich zu einer Verkrümmung in einer Richtung, die linear unabhängig zu einer Richtung der Querkontraktion ist, kann neben einer Aktuatorkraft auch eine erhöhte strukturelle Steifigkeit zur Herstellung eines Kontaktes nutzbar sein, so dass Kontaktkräfte erhöht und/oder ein Kontaktprellen der mechanischen Kontakte reduzierbar ist.

Gemäß einem Ausführungsbeispiel der vorliegenden Erfindung ist eine Aktuatorplatte gegenüber einer Anschlagsfläche auslenkbar. Die auslenkbare Aktuatorplatte weist eine einstückige piezoelektrische Funktionsschicht auf, die die Aktuatorplatte zumindest teilweise bedeckt. Die auslenkbare Aktuatorplatte weist einen angesteuerten und einen nicht angesteuerten Zustand auf und ist ausgebildet, um in wenigstens einem der beiden Zustände eine Hohlwölbung auszuführen. Die Anschlagsfläche ist einer Hohlseite der auslenkbaren Aktuatorplatte zugewandt angeordnet. In dem Zustand, in welchem die Aktuatorplatte die Hohlwölbung ausführt, kann die auslenkbare Aktuatorplatte einen mechanischen Kontakt zu der Anschlagsfläche bereitstellen. In einem anderen Zustand ist die auslenkbare Aktuatorplatte beabstandet zu der Anschlagsfläche.

Vorteilhaft an diesem Ausführungsbeispiel ist, dass basierend auf der Hohlwölbung eine Kontaktkraft zwischen der Anschlagsfläche und der auslenkbaren Aktuatorplatte groß gegenüber einem Balkenelement sein kann und gleichzeitig eine einfache Ansteuerung der piezoelektrischen Funktionsschicht, etwa durch zwei Betriebszustände "angesteuert (an)" und "nicht angesteuert (aus)" ermöglicht ist.

Gemäß einem weiteren Ausführungsbeispiel der vorliegenden Erfindung weist die piezoelektrische Funktionsschicht eine aktive Fläche auf, in die ein Ellipsenring projizierbar ist, der zu mehr als 95% mit der Fläche der piezoelektrischen Funktionsschicht überlappt und dessen Fläche gleichzeitig wenigstens 50% oder 60% einer Fläche der auslenkbaren Aktuatorplatte einnimmt.

Vorteilhaft an diesem Ausführungsbeispiel ist, dass eine Ellipse eine Ausbildung der aktiven Fläche und mithin ein Ausführen der Hohlwölbung entlang zweier linear unabhängiger Richtungen ermöglicht.

Weitere vorteilhafte Ausführungsformen sind der Gegenstand der abhängigen Patentansprüche.

Bevorzugte Ausführungsbeispiele der vorliegenden Erfindung werden nachfolgend Bezug nehmend auf die beiliegenden Zeichnungen erläutert. Es zeigen:
- Fig. 1a: eine schematische Seitenschnittansicht eines Mikro-Elektro-Mechanischen Systems (MEMS) mit einer auslenkbaren Aktuatorplatte in einem Off-State gemäß einem Ausführungsbeispiel der vorliegenden Erfindung;
- Fig. 1b: eine schematische Seitenschnittansicht des MEMS aus Fig. 1a in einem OnState;
- Fig. 1c: das MEMS aus Fig. 1a in einem linken Bildbereich in einer schematische Aufsicht auf die auslenkbare Aktuatorplatte mit einer Schnittebene und in einem rechten Bildbereich einer schematischen Seitenschnittansicht in der Schnittebene;
- Fig. 2a: eine schematische Aufsicht auf eine auslenkbare Aktuatorplatte, die gemäß einem Ausführungsbeispiel der vorliegenden Erfindung eine in etwa dreieckige Geometrie der Hauptseite mit einer Fläche aufweist;
- Fig. 2b: eine schematische Aufsicht auf eine auslenkbare Aktuatorplatte mit einer runden Hauptseitengeometrie, die eine innere Aussparung aufweist gemäß einem Ausführungsbeispiel der vorliegenden Erfindung;
- Fig. 2c: eine schematische Aufsicht auf eine auslenkbare Aktuatorplatte gemäß einem Ausführungsbeispiel der vorliegenden Erfindung, deren Geometrie durch eine äquidistante Überlagerung einer Vielzahl von Kreisen entlang einer Kreisbahn beschrieben werden kann;
- Fig. 2d: eine schematische Aufsicht auf eine auslenkbaren Aktuatorplatte gemäß einem Ausführungsbeispiel der vorliegenden Erfindung mit einer Hauptseite, die eine elliptische Form aufweist;
- Fig. 2e: eine schematische Aufsicht auf eine auslenkbaren Aktuatorplatte gemäß einem Ausführungsbeispiel der vorliegenden Erfindung, die eine runde Form analog zu der auslenkbaren Aktuatorplatte aus Fig. 2b aufweist und deren ringförmige Struktur eine Aussparung aufweist;
- Fig. 3: in einem oberen Abschnitt eine schematische Aufsicht auf ein MEMS mit einer auslenkbaren Aktuatorplatte, die über zwei Federelemente an zwei Ankern aufgehängt ist, in einem mittleren Abschnitt das MEMS in einer schematischen Seitenschnittansicht in einem Off-State und in einem unteren Abschnitt eine schematische Seitenschnittansicht des MEMS in dem On-State gemäß einem Ausführungsbeispiel der vorliegenden Erfindung;
- Fig. 4: schematische Ansichten eines MEMS, dessen auslenkbaren Aktuatorplatte eine innere Aussparung aufweist gemäß einem Ausführungsbeispiel der vorliegenden Erfindung;
- Fig. 5: schematische Ansichten eines MEMS, das eine Statorelektrode 58 aufweist gemäß einem Ausführungsbeispiel der vorliegenden Erfindung;
- Fig. 6: schematische Ansichten eines MEMS mit einer auslenkbaren Aktuatorplatte, die mittels drei Ankern mit einer zweiten Anschlagsfläche verbunden ist gemäß einem Ausführungsbeispiel der vorliegenden Erfindung;
- Fig. 7: schematische Ansichten eines MEMS, mit einer auslenkbaren Aktuatorplatte, die gegenüber dem MEMS aus Fig. 6 zusätzlich an einer durch die Aussparung definierten inneren Mantelfläche der auslenkbaren Aktuatorplatte mittels vier innerer Ankerpunkte fixiert ist gemäß einem Ausführungsbeispiel der vorliegenden Erfindung;
- Fig. 8a: eine schematische Seitenschnittansicht eines Mikroventils, das eine auslenkbare Aktuatorplatte aufweist gemäß einem Ausführungsbeispiel der vorliegenden Erfindung in einem Off-State;
- Fig. 8b: das Mikroventil aus Fig. 8a in einem On-State;
- Fig. 9a: ein alternatives Mikroventil mit einer auslenkbaren Aktuatorplatte in dem Zustand, in dem die auslenkbare Aktuatorplatte die Hohlwölbung ausführt;
- Fig. 9b: das Mikroventil aus Fig. 9a in einem Zustand, in welchem die auslenkbare Aktuatorplatte einen ebenen Zustand aufweist;
- Fig. 10: Ergebnisse einer Finite-Elemente-Modulierung (FEM) eines MEMS, das einen Aufbau aufweist, wie er für das MEMS in der Fig. 7 beschrieben ist;
- Fig. 11: Ergebnisse von FEM-Berechnungen zweier MEMS mit einer Struktur analog dem MEMS aus der Fig. 9, mit einer Abwesenheit innerer Verankerungspunkte, wie es in der Fig. 6 dargestellt ist;
- Fig. 12: schematische dreidimensionale Ansichten zweier MEMS, wobei eine auslenkbare Aktuatorplatte eines MEMS sogenannte "Release Holes" aufweist und ist mittels vier Federelementen an einem nicht-dargestellten Substrat aufgehängt ist;
- Fig. 13: Ergebnisse von FEM-Berechnungen zweier MEMS mit einer auslenkbare Aktuatorplatte die gegenüber der auslenkbaren Aktautorplatte in Fig. 7 an einem äußeren Umfang der auslenkbaren Aktuatorplatte angeordnete Kontaktbereiche aufweist, die über die gemeinsame bewegliche Elektrode verbunden sind; und
- Fig. 14: Ergebnisse von FEM-Berechnungen zweier MEMS, wobei ein MEMS gegenüber dem MEMS aus Fig. 11 die Anker an einer inneren Aussparung der auslenkbaren Aktuatorplatte aufweist und das andere MEMS gegenüber dem MEMS aus Fig. 11 zwei weitere Kontaktbereiche aufweist.

Bevor nachfolgend Ausführungsbeispiele der vorliegenden Erfindung im Detail anhand der Zeichnungen näher erläutert werden, wird darauf hingewiesen, dass identische, funktionsgleiche oder gleichwirkende Elemente, Objekte und/oder Strukturen in den unterschiedlichen Figuren mit den gleichen Bezugszeichen versehen sind, so dass die in unterschiedlichen Ausführungsbeispielen dargestellte Beschreibung dieser Elemente untereinander austauschbar ist bzw. aufeinander angewendet werden kann.

Ein Zustand, in welchem eine elektrische Spannung an einer piezoelektrischen Funktionsschicht angelegt ist, wird im Folgenden als "an" bzw. dem englischen Begriff "On-State" bezeichnet. Ein Zustand, in welchem die piezoelektrische Funktionsschicht spannungsfrei ist, wird im Folgenden als "aus" bzw. dem englischen Begriff "Off-State" bezeichnet. Nachfolgende Erläuterungen beschreiben auslenkbare Aktuatorplatten derart, dass selbige ausgebildet sind, um im On-State eine Hohlwölbung auszuführen und einen mechanischen Kontakt mit einer Anschlagsfläche bereitzustellen und, um im Off-State beabstandet von der Anschlagsfläche zu sein. Es versteht sich, dass basierend auf mechanischen oder elektrischen Vorspannungen in der piezoelektrischen Funktionsschicht und/oder mechanischen Spannungen zwischen der piezoelektrische Funktionsschicht und einem Substrat der auslenkbaren Aktuatorplatte, an dem die piezoelektrische Funktionsschicht angeordnet ist und/oder einer mechanischen Vorspannung der auslenkbaren Aktuatorplatte selbige ausgebildet sein kann, um im Off-State die Hohlwölbung auszuführen und, um im On-State beanstandet zu der ersten Anschlagsfläche zu sein. Die auslenkbaren Aktuatorplatte kann in dem Zustand, in dem Sie beanstandet zu der ersten Anschlagsfläche ist, beispielsweise eben ausgebildet sein, eine Krümmung oder eine Hohlwölbung aufweisen. Das bedeutet, dass Erläuterungen bezüglich des On-States und bezüglich des Off-States wechselseitig vertauschbar sind.

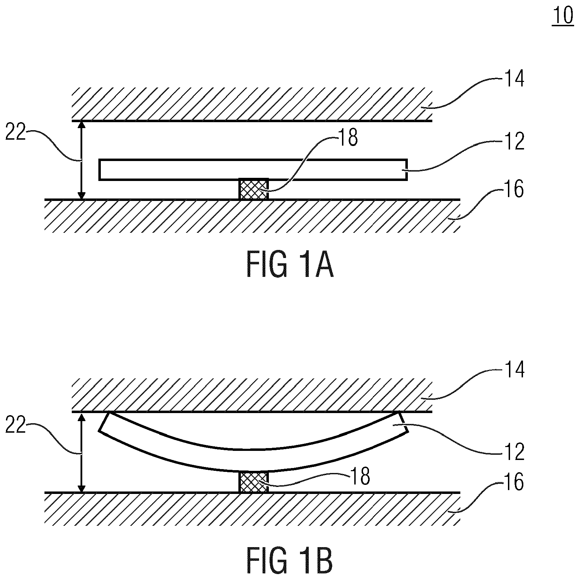

Fig. 1a zeigt eine schematische Seitenschnittansicht eines Mikro-Elektro-Mechanischen Systems (MEMS) 10 mit einer auslenkbaren Aktuatorplatte 12, die zwischen einer Anschlagsfläche bzw. einer ersten Anschlagsfläche 14 und einer weiteren, d.h. zweiten Anschlagsfläche 16 angeordnet ist. Die auslenkbare Aktuatorplatte 12 ist mit einem Anker 18 verbunden. Der Anker 18 ist an einer der auslenkbaren Aktuatorplatte 12 abgewandten Seite mit der zweiten Anschlagsfläche 16 fest verbunden, so dass die auslenkbare Aktuatorplatte 12 mittels des Ankers 18 an der zweiten Anschlagsfläche 16 abgestützt ist. Der Anker kann auch einstückig mit der zweiten Anschlagsfläche 16 gebildet sein und/oder als Ankerelement bezeichnet werden.

In anderen Worten ist der Anker 18 ausgebildet, um eine feste Verankerung, engl. (rigid anchoring) der auslenkbaren Aktuatorplatte 12 bereitzustellen. Ein Ausmaß, in welchem eine Verformung der auslenkbaren Aktuatorplatte 12 durch die Kopplung mit dem Anker 18 beeinflusst ist, kann durch eine Reduzierung einer Fläche, in der der Anker 18 mit der auslenkbaren Aktuatorplatte 12 verbunden ist, beeinflusst bzw. reduziert werden. ist. Der Anker 18 kann auch abseits einer mittigen Position der auslenkbaren Aktuatorplatte 12 angeordnet sein, wie es später noch gezeigt wird.

Die erste Anschlagsfläche 14 und die zweite Anschlagsfläche 16 sind beispielsweise parallel zueinander angeordnet und weisen einen Abstand 22 zueinander auf. Die auslenkbare Aktuatorplatte 12 umfasst einen piezoelektrischen Aktuator und ist ausgebildet, um bei einem Anlegen einer elektrischen Spannung an den piezoelektrischen Aktuator eine Hohlwölbung auszuführen. In der Fig. 1a ist die auslenkbare Aktuatorplatte 12 in einem Zustand dargestellt, in welchem die auslenkbare Aktuatorplatte 12 beabstandet zu der ersten Anschlagsfläche 14 ist. Der Abstand 22 kann beispielsweise in einem Bereich von 0,01 bis 50 µm, 0,05 bis 10 µm oder 0,1 bis 5 µm oder auch bei größeren Werten liegen und beispielsweise einen Wert von 50 µm aufweisen.

Fig. 1b zeigt eine schematische Seitenschnittansicht des MEMS 10 in einem On-State. Der Abstand 22 ist basierend auf einer festen Einspannung der ersten Anschlagsfläche 14 und der zweiten Anschlagsfläche 16 gegenüber der Fig. 1a unverändert. Alternativ kann die erste Anschlagsfläche 14 und/oder die zweite Anschlagsfläche 16 weich, das heißt nachgiebig, gegenüber der jeweils anderen Anschlagsfläche 16 oder 14 angeordnet sein. Das bedeutet dass der Abstand 22 basierend auf einer Kraft veränderlich sein kann, mit der die auslenkbare Aktuatorplatte 12 den mechanischen Kontakt zu der ersten Anschlagsfläche 14 bereitstellt (Kontaktkraft). In anderen Worten kann basierend auf der Kontaktkraft, mit der der mechanische Kontakt bereitgestellt wird, die erste Anschlagsfläche 14 von der zweiten Anschlagsfläche 16 weggedrückt werden oder umgekehrt.

Die auslenkbare Aktuatorplatte 12 weist eine Geometrie mit einer Gesamtfläche A_{AP} auf, die über eine aktiven Fläche A_{PS} hinweg von einer piezoelektrischen Funktionsschicht bedeckt ist. Wie es in nachfolgenden Figuren beschrieben ist, existiert ein Ellipsenring, der eine Ellipsenringfläche A_{ER} aufweist, der mit seiner Ellipsenringfläche A_{ER} zu mehr als 95% mit der aktiven Fläche A_{PS} überlappt und dessen Ellipsenringfläche A_{ER} wenigstens 60% der Gesamtfläche A_{AP} einnimmt. Im Folgenden wird dies auch manchmal als "Ellipsenringbedingung" bezeichnet. Den Ellipsenring kann man sich als eine auf die auslenkbare Aktuatorplatte 12 projizierte Fläche vorstellen. Wenn die Ellipsenringbedingung erfüllt ist, bedeutet dies, dass die Platte eine für eine gewünscht hohe Kontaktkraft gegenüber der Anschlagsfläche 14 eine Hohlwölbung ausführt.

Alternative Ausführungsbeispiele schaffen auslenkbare Aktuatorplatten, für die der Ellipsenring mit seiner Ellipsenringfläche A_{ER} zu mehr als 80% oder 90% mit der aktiven Fläche A_{PS} überlappt und dessen Ellipsenringfläche A_{ER} wenigstens 50%, 55% der Gesamtfläche A_{AP} einnimmt.

Der Ellipsenring weist zumindest eine äußere Ellipsenbahn mit einer Hauptachse und einer senkrecht dazu angeordneten Nebenachse auf, wobei die Hauptachse die beiden Hauptscheitel und die Nebenachse die beiden Nebenscheitel der äußeren Ellipsenbahn verbinden. Ein Verhältnis zwischen der Hauptachse und der Nebenachse weist einen Wert von größer oder gleich 0,25 und kleiner oder gleich 4 auf. Weist das Verhältnis beispielsweise einen Wert von 1 auf, so kann der Ellipsenring kreisförmig gebildet sein. Beispielsweise kann die auslenkbare Aktuatorplatte 12 und/oder die piezoelektrische Funktionsschicht kreisförmig gebildet sein. Eine kreisförmige auslenkbare Aktuatorplatte 12 ermöglicht einen mechanischen Kontakt zwischen der auslenkbaren Aktuatorplatte 12 und der ersten Anschlagsfläche 14 in einem kreisförmigen Kontaktbereich. Die erste Anschlagsfläche 14 ist einer Hohlseite der auslenkbaren Aktuatorplatte 12 zugewandt angeordnet. Die Hohlseite ist diejenige Hauptseite der auslenkbaren Aktuatorplatte 12, die, etwa in einer Seitenschnittansicht, einen geringeren Krümmungsradius aufweist, wenn die auslenkbare Aktuatorplatte 12 die Hohlwölbung ausführt. Die innere Ellipsenbahn kann fehlen, in welchem Fall er Ellipsenring zu einer Ellipse degeneriert. Vorzugsweise sieht die "Ellipsenringbedingung" vor, dass der Ellipsenring eine ausreichende Breite hat. Beispielsweise kann eine ausreichende Breite einen Wert des Ellipsenrings von zumindest 10 µm 100 µm, 1.000 µm oder 5000 µm bedeuten

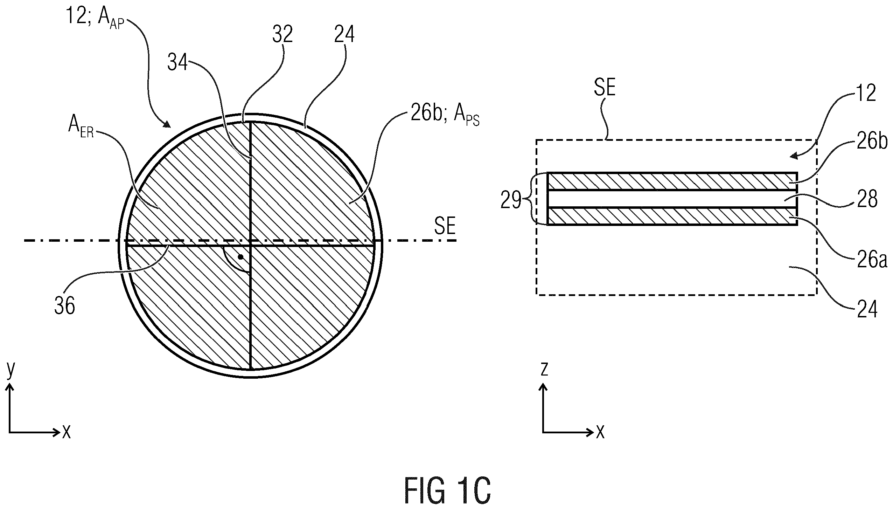

Fig. 1c zeigt in einem linken Bildbereich eine schematische Aufsicht auf die auslenkbare Aktuatorplatte 12 mit einer Schnittebene SE und in einem rechten Bildbereich eine schematische Seitenschnittansicht in der Schnittebene SE.

Die auslenkbare Aktuatorplatte 12 umfasst ein Substrat 24. Das Substrat 24 weist ein zylindrisches Volumen in Form einer runden Platte auf. Die zylindrische Platte weist zwei Hauptseiten und eine Mantelseite auf, wobei die Hauptseiten die Deckelflächen des Zylinderkörpers sind. An einer Hauptseite des Substrats 24 ist eine erste Elektrode 26a angeordnet, die das Substrat 24 teilweise bedeckt. Alternativ kann die erste Elektrode 26 das Substrat 24 auch vollständig bedecken oder darüber hinausragen. An einer dem Substrat 24 abgewandten Hauptseite der ersten Elektrode 26a ist ein piezoelektrisches Material 28 angeordnet, das an einer der ersten Elektrode 26a abgewandten Hauptseite von einer zweiten Elektrode 26b bedeckt ist. Die erste Elektrode 26a, die zweite Elektrode 26b und das piezoelektrische Material 28 bilden eine piezoelektrische Funktionsschicht 29. Basierend auf einer zwischen der ersten Elektrode 26a und der zweiten Elektrode 26b angelegten elektrischen Spannung ist die piezoelektrische Funktionsschicht 29 ausgebildet, um das Substrat 24 zu verformen und mithin die Hohlwölbung in der auslenkbaren Aktuatorplatte zu induzieren. Eine Verwölbungsrichtung der auslenkbaren Aktuatorplatte 12 kann von der Abfolge von passiver und aktiver Schichten im Aktuatorstack bestimmt sein. Eine derartige Konfiguration aus Substrat 2 und piezoelektrischer Funktionsschicht kann als Bimorph bezeichnet werden. Alternativ kann das Substrat ebenfalls eine piezoelektrische Funktionsschicht sein. Alternativ oder zusätzlich kann eine weitere piezoelektrische Funktionsschicht an einer der piezoelektrischen Funktionsschicht 29 abgewandten Hauptseite des Substrates 24 angeordnet und bspw. unabhängig von der piezoelektrischen Funktionsschicht ansteuerbar sein. Eine derartige Konfiguration kann als Trimorph bezeichnet werden. Alternativ oder zusätzlich können auch eine oder mehrere weitere Funktionsschichten an der piezoelektrischen Funktionsschicht 29 angeordnet werden und bspw. einen Stapel bilden. Mittels eines Stapels von piezoelektrischen Funktionsschichten kann eine Aktuatorkraft gegenüber einer Aktuatorkraft mittels der piezoelektrischen Funktionsschicht 29 vergrößert werden.

Die piezoelektrische Funktionsschicht 29 ist einstückig gebildet. Als einstückige piezoelektrische Funktionsschicht 29 wird verstanden, dass beispielsweise das piezoelektrische Material 28 einstückig gebildet sein kann. Alternativ kann das piezoelektrische Material 28 auch aus mehreren Elementen gebildet sein und von einstückigen Elektroden 26a und 26b umschlossen sein. Alternativ kann auch das piezoelektrische Material 28 und die Elektroden 26a und/oder 26b mehrere Elemente aufweisen und ein elektrische Feld zur Ansteuerung des piezoelektrischen Materials 28 von mehreren, gemeinsam angesteuerten Elektrodensegmenten bereitgestellt werden. Das bedeutet, dass die piezoelektrische Funktionsschicht 29 flächig zu einem Zeitpunkt ansteuerbar ist. Dies wird im Nachfolgenden als einstückige piezoelektrische Funktionsschicht 29 bezeichnet.

Die auslenkbare Aktuatorplatte 12 weist eine Gesamtfläche A_{AP} einer Hauptseitenfläche auf. Die erste Elektrode 26a, das piezoelektrische Material 28 und die zweite Elektrode 26b weisen eine aktive Hauptseitenfläche A_{PS} auf, die die Fläche der piezoelektrischen Funktionsschicht 29 bezeichnet, die mittels der Elektroden 26a und 26b aktivierbar, das heißt ansteuerbar ist. Ein Ellipsenring 32 mit der Ellipsenringfläche A_{ER} überlappt beispielsweise zu 100% mit der aktiven Fläche A_{PS} und weist eine Ellipsenringfläche A_{ER} auf. Die Ellipsenringfläche A_{ER} nimmt wenigstens 50 % und wenigstens 60%, beispielsweise mehr als 80% und mehr als 90%, der Gesamtfläche A_{AP} ein.

Der Ellipsenring 32 weist eine Hauptachse 34 und eine Nebenachse 36 auf, wobei die Hauptachse 34 und die Nebenachse 36 in einem rechten Winkel zueinander angeordnet sind. Wenn beide Brennpunkte des äußeren Ellipsenrings 32 auf den selben Punkt abgebildet werden, kann aus dem Ellipsenring 32 ein Kreis resultieren, dessen Hauptachse 34 und Nebenachse 36 jeweils eine Länge aufweisen, die dem Durchmesser des Kreises entspricht, so dass die Hauptachse 34 und die Nebenachse 36 ein Verhältnis von 1:1 und mithin mit einem Wert von 1 aufweisen können. Der Ellipsenring 32 weist ferner eine Breite zwischen einer äußeren Ellipsenbahn und einer inneren Ellipsenbahn auf. Die Breite entspricht beispielsweise dem Radius des Kreises, so dass die Ellipsenringfläche A_{ER} eine Vollfläche ist und der aktiven Fläche A_{PS} entspricht.

Die Auslenkung der piezoelektrischen Funktionsschicht kann zu einer Auslenkung der auslenkbaren Aktuatorplatte entlang der Hauptachse 34 und entlang der Nebenachse 36 und mithin zu einer Hohlwölbung der auslenkbaren Aktuatorplatte 12 führen. Die Hohlwölbung kann eine sphärische Verwölbung sein, etwa wenn die Hohlwölbung rotationssymmetrisch bezüglich eines geometrischen Mittelpunktes der Hauptseite der auslenkbaren Aktuatorplatte 12 ist.

Alternative Ausführungsbeispiele zeigen Ellipsenringe mit einem Verhältnis zwischen der Hauptachse und der Nebenachse, das einen Wert in einem Bereich von größer oder gleich 0,25 und kleiner oder gleich 4, größer oder gleich 0,3 und kleiner oder gleich 3 oder größer oder gleich 0,35 und kleiner oder gleich 2,85, größer oder gleich 0,5 und kleiner oder gleich 2, größer oder gleich 0,75 und kleiner oder gleich 1,3 aufweist.

Das Verhältnis von Haupt- und Nebenachse in diesem Bereich kann so ausgedrückt werden, dass die piezoelektrische Funktionsschicht eine gewisse Abmessung in einer zweite Richtung, beispielsweise einer y-Richtung, bezogen auf eine Abmessung in eine senkrecht dazu stehende erste Richtung, beispielsweise eine x-Richtung, aufweist. Bei einem Verhältnis zwischen Hauptachse 34 und Nebenachse 36 mit einem Wert von 1 sind beispielsweise eine Breite in x-Richtung und eine Länge in y-Richtung gleich.

Die gewisse Abmessung in der zweiten Richtung ermöglicht das Ausführen der Hohlwölbung, um die hohen Kontaktkräfte bereitzustellen.

Eine Aktuatorgeometrie, etwa mit einer runden auslenkbaren Aktuatorplatte 12, kann punktuell hohe Kräfte bereitstellen. Insbesondere kann dies dadurch ermöglicht werden, dass eine Hebellänge in einer Richtung zwischen einem Stützpunkt, an dem beispielsweise der Anker 18 angeordnet ist, und einem Kontaktpunkt oder -bereich, in welchem der mechanische Kontakt zwischen der auslenkbaren Aktuatorplatte 12 und der Anschlagsfläche 14 bereitstellbar ist, kleiner bzw. kürzer ist, als die jeweilige Abmessung des Aktuators entlang dieser Richtung, beispielsweise der Durchmesser. Eine Hebellänge kann in etwa die Länge des Kreisradius, oder in etwa die Länge der halben Haupt- oder Nebenachse 34 oder 36 aufweisen, während der Aktuator den Durchmesser als Abmessung in dieser Richtung aufweist.

Eine verkürzte Hebellänge ermöglicht eine vergrößerte strukturelle Steifigkeit entlang der verkürzten Hebellänge, so dass eine Kontaktkraft, mit der der mechanische Kontakt bereitstellbar ist, vergrößert sein kann. Basierend auf einer festen einseitigen Verankerung mittels des Ankers 18 können auch bei größeren Abständen 22, etwa 5 µm oder 10 µm oder 20 µm oder 50 µm hohe Kräfte generiert werden.

Ein Aktuator mit einer Hauptseitengeometrie, in welcher die Abmessung des Aktuators in einer ersten Richtung, beispielsweise einer Breite, gegenüber einer Abmessung in einer anderen Richtung, beispielsweise einer Länge, wesentliche Effekte beiträgt, kann als dreidimensionaler (3D) Aktuator bezeichnet werden. Ein 3D-Aktuator, etwa die auslenkbare Aktuatorplatte 12, kann ausgebildet sein, die Hohlwölbung basierend auf einer Nutzung der Expansion oder Kontraktion der piezoelektrischen Funktionsfläche in zwei oder mehreren linear unabhängigen Raumrichtung entlang einer Hauptseite des Aktautors, etwa einer Hohlseite, bereitzustellen.

Die auslenkbare Aktuatorplatte 12 kann in anderen Worten als Stack umfassend eine passive Schicht 24 und das piezoelektrischen Material 28, eingebettet zwischen zwei Elektroden 26a und 26b gebildet sein. Die Verwölbungsrichtung kann basierend auf der Seite des Stacks, an der sich die aktive piezoelektrische Schicht befindet, einstellbar sein. Die Fig. 1a-c zeigen schematische Seiten- oder Querschnittansichten durch einen Aktuator, basierend auf einer kreisrunden Platte. Die auslenkbare Aktuatorplatte 12 befindet sich zwischen zwei Begrenzungsflächen 14 und 16.

In anderen Worten zeigen die Figuren 1a und 1b einen runden Aktuator, der sich zwischen zwei Begrenzungsflächen (bounding surfaces - den Anschlagsflächen 14 und 16) in definierten Abständen befindet. Wird der Aktuator betätigt und verwölbt sich, kommt es zu einem mechanischen Kontakt mit der oberen Begrenzungsfläche, das heißt der ersten Anschlagsfläche 14. Im Falle, dass die auslenkbare Aktuatorplatte 12 als runde Platte ausgeführt ist, kann der mechanische Kontakt entlang des ganzen Randes der auslenkbaren Aktuatorplatte 12 gebildet sein. Der Abstand 22 kann so gewählt werden, dass ein Ort, an dem der mechanische Kontakt an der ersten Anschlagsfläche 14 gebildet ist, einstellbar ist. So kann beispielsweise in der Fig. 1b ein vergrößerter Abstand 22 dazu führen, dass die von der auslenkbaren Aktuatorplatte 12 ausgeführte Hohlwölbung verstärkt, ein Abstand zwischen den beiden dargestellten Kontaktpunkten bzw. ein Radius oder ein Verlauf eines umlaufenden Kontaktbereichs verringert ist.

In anderen Worten können durch Ausnutzung der Höhlwölbung oder einer sphärischen Verwölbung bei gegebener Fläche höhere Kontaktkräfte als mit konventionellem Designs gemäß dem Stand der Technik, beispielsweise einem Balken, der eine Länge aufweist, die einem Durchmesser einer Aktuatorplatte entspricht, generiert werden. Die Wölbung liefert entlang zweier linear unabhängiger Richtungen einen Beitrag zur strukturellen Steifigkeit. Das bedeutet, dass die Aktuatorplatte nicht so leicht einknickt.

Das MEMS 10 kann beispielsweise über eine Steuereinrichtung ansteuerbar sein. Die Steuereinheit kann ausgebildet sein, um die auslenkbare Aktuatorplatte, beispielsweise durch ein Bereitstellen elektrischer Energie, anzusteuern. Die Steuereinheit kann mit dem MEMS gekoppelt, das heißt verbunden sein.

Alternative Ausführungsbeispiele schaffen MEMS mit piezoelektrischen Funktionsschichten, die eine Fläche aufweisen, in die ein Ellipsenring projizierbar ist, der zu mehr als 96%, 97% oder 99% mit der Fläche der piezoelektrischen Funktionsschicht überlappt und dessen Fläche gleichzeitig wenigstens 50%, 70%, 80% oder 85% einer Fläche der auslenkbaren Aktuatorplatte einnimmt.

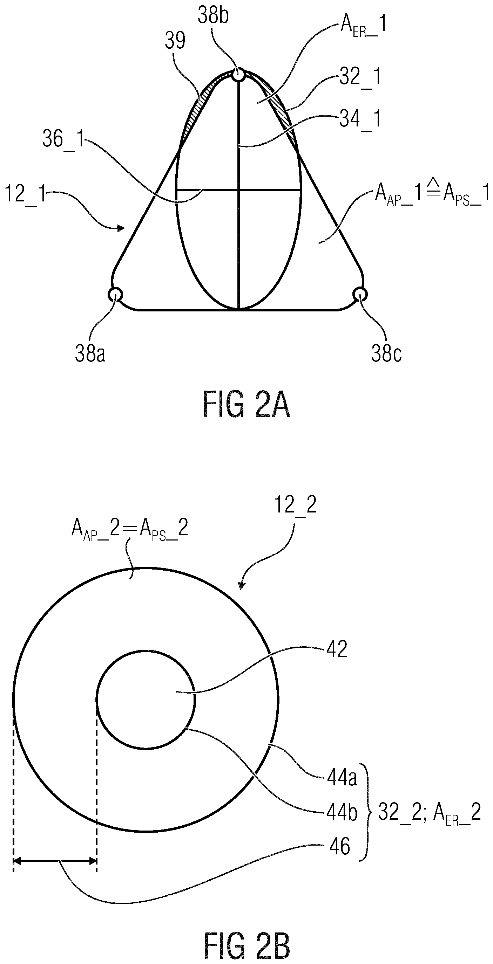

Fig. 2a zeigt eine schematische Aufsicht auf eine auslenkbare Aktuatorplatte 12_1, die eine in etwa dreieckige Geometrie der Hauptseite mit einer Gesamtfläche A_{AP}_1 aufweist. Eine piezoelektrische Funktionsschicht bedeckt eine Hauptseite der auslenkbaren Aktuatorplatte 12_1 vollständig, so dass die Gesamtfläche A_{AP}_1 einer aktiven Fläche A_{PS}_1 der piezoelektrischen Funktionsschicht entspricht. Ein Ellipsenring 32_1 bzw. dessen Ellipsenringfläche A_{ER}_1 überlappt zu mehr als 95% mit der aktiven Fläche A_{PS}_1. Flächen 39, an denen der Ellipsenring nicht mit der aktiven Fläche überlappt, weisen einen (verbleibenden) Anteil von weniger als 5% auf. Ein Verhältnis einer Hauptachse 34_1 des Ellipsenrings 32_1 und einer Nebenachse 36_1 weist einen Wert von etwa 0,54 bzw. 1,85 auf. Die auslenkbare Aktuatorplatte 12_1 weist an abgerundeten Ecken der dreieckigen Geometrie Kontaktbereiche 38a, 38b und 38c mit je einer Elektrode auf. Führt die auslenkbare Aktuatorplatte 12_1 eine Hohlwölbung in eine Richtung eines Betrachters der Fig. 2a aus, so kann der mechanische Kontakt zwischen den Elektroden und einer Anschlagsfläche bzw. dort angeordneten Elektroden bereitgestellt werden.

Alternative Ausführungsbeispiele schaffen auslenkbare Aktuatorplatten, deren Gesamtfläche mit einen Ellipsenring zu mindestens 60%, 70, 80%, 90% überlappt.

Vorteilhaft an dieser Ausführungsform ist, dass die Elektroden beispielsweise unterschiedliche elektrische Potentiale aufweisen können, so dass basierend auf einem mechanischen Kontakt zwischen den Elektroden in den Kontaktbereichen 38a-c und Elektroden an der Anschlagsfläche unterschiedliche Strompfade geöffnet oder geschlossen werden können. Bei einer Abwesenheit von Elektroden können an Orten derselben mechanische Kontaktbereiche verbleiben, so dass im Vergleich zu Ausführungen der Fig. 1 eine Fläche eines mechanischen Kontaktbereichs bspw. von einem Kontaktring auf Flächen der drei Kontaktbereiche reduziert ist.

Fig. 2b zeigt eine schematische Aufsicht auf eine auslenkbare Aktuatorplatte 12_2 mit einer runden Hauptseitengeometrie, die eine innere Aussparung 42 aufweist. Die innere Aussparung 42 weist ebenfalls eine runde Form auf. Alternativ kann die Aussparung 42 eine beliebige Form aufweisen. Die piezoelektrische Funktionsschicht bedeckt das Substrat der auslenkbaren Aktuatorplatte 12_2 vollständig, so dass eine Gesamtfläche A_{AP}_2 der auslenkbaren Aktuatorplatte einer aktiven Fläche A_{PS}_2 einer piezoelektrischen Funktionsschicht entspricht. Weisen die auslenkbare Aktuatorplatte 12 in Fig. 1c und die auslenkbare Aktuatorplatte 12_2 in Fig. 2b gleiche Radien äußerer Umfänge auf, so kann die Gesamtfläche A_{AP}_2 der Gesamtfläche A_{AP} abzüglich einer Fläche der Aussparung 42 entsprechen.

Ein Ellipsenring 32_2 weist eine äußere Ellipsenbahn 44a und eine innere Ellipsenbahn 44b auf. Die innere Ellipsenbahn 44b kann bspw. durch einen Verlauf der Aussparung 42 oder einem Abstand zwischen der äußeren Ellipsenbahn 44a und der inneren Ellipsenbahn 44b bestimmt sein. Die äußere Ellipsenbahn 44a und die innere Ellipsenbahn 44b verlaufen parallel zueinander und weisen einen Abstand 46 zueinander auf. Der Abstand 46 kann auch als Breite des Ellipsenrings 32_2 bezeichnet werden. Eine Ellipsenringfläche A_{ER}_2 kann deckungsgleich mit der Gesamtfläche A_{AP_}2 und der aktiven Fläche A_{PS}_2 sein, so dass die Ellipsenringfläche A_{ER}_2 zu mehr als 95%, beispielsweise 100%, mit der aktiven Fläche A_{PS}_2 überlappt. Die Ellipsenringfläche A_{ER}_2 kann 100% der Fläche A_{AP}_2 (Gesamtfläche) der auslenkbaren Aktuatorplatte 12_2 einnehmen. Eine durch die Nebenachse 36_1 definierte Breite des Ellipsenrings 32_1 in der Fig. 2a ist beispielsweise größer oder gleich der Hälfte einer Abmessung der Hauptachse 34_1, so dass der Ellipsenring 32_1 eine Vollfläche bildet.

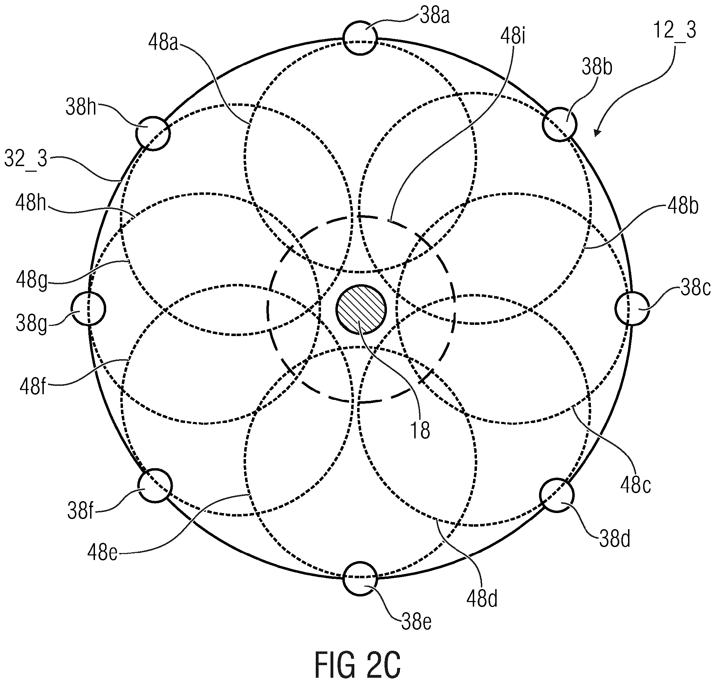

Fig. 2c zeigt eine schematische Aufsicht auf eine auslenkbare Aktuatorplatte 12_3, deren Geometrie beispielsweise durch eine äquidistante Überlagerung einer Vielzahl von Kreisen 48a-i mit gleichem oder unterschiedlichem Durchmesser entlang einer Kreisbahn und konzentrisch bezüglich des geometrischen Mittelpunktes des Kreises beschrieben werden kann. Die auslenkbare Aktuatorplatte 12_3 weist eine Vielzahl von Kontaktbereichen 38a-h auf, an denen Elektroden angeordnet sind. In einer Mitte der auslenkbaren Aktuatorplatte 12_3 ist der Anker 18 angeordnet. Ist die piezoelektrische Funktionsschicht beispielsweise in Richtung des Betrachters an der auslenkbaren Aktuatorplatte 12_3 angeordnet, so kann die Hohlwölbung beispielsweise ebenfalls in Richtung des Betrachters ausführbar sein. Die auslenkbare Aktuatorplatte kann den Anker 18 in dem Zustand, in dem sie die Hohlwölbung ausführt, zumindest teilweise umschließen, das heißt, die Hohlwölbung kann in Richtung des Ankers 18, ausführbar sein. Die Kontaktbereichen 38a-h bzw. Elektroden sind entlang einer Kreisbahn angeordnet, die einer äußeren Ellipsenbahn eines Ellipsenrings 32_3 entspricht. Die Kontaktbereiche 38a-h können bspw. auch punktförmig sein.

In anderen Worten kann ein Kontaktring, wie er beispielsweise durch die auslenkbare Aktuatorplatte 12 in Fig. 1 bereitgestellt wird, in mehrere Kontaktbereiche unterteilt werden. Die Kontaktbereiche 38a-h können äquidistant oder mit variierenden Abständen zu einander auf der Kreisbahn angeordnet sein. Alternativ können Kontaktbereiche 38a-h können in einem Toleranzbereich um die Kreisbahn herum angeordnet sein. Der Toleranzbereich kann einen Wert von weniger als ±25 %, weniger als ±15 % oder weniger als ±5 % des Durchmessers der Kreisbahn um selbige aufweisen.

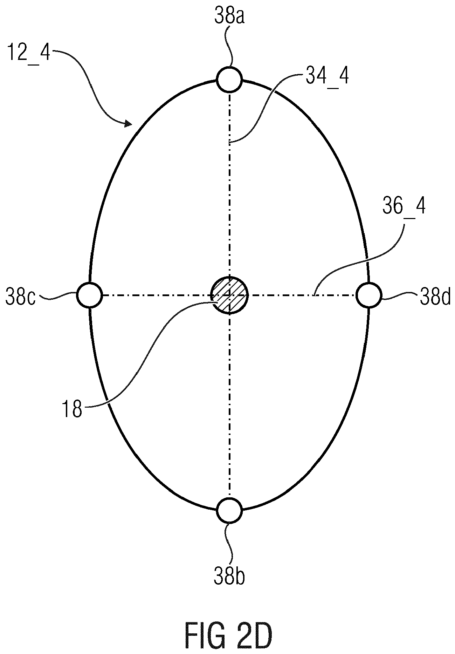

Fig. 2d zeigt eine schematische Aufsicht auf eine Hauptseite einer auslenkbaren Aktuatorplatte 12_4, die eine elliptische Form aufweist. Die Kontaktbereiche 38a-d sind entlang des elliptischen Umfangs, d. h. entlang einer elliptischen bzw. ellipsenförmigen Bahn, angeordnet. Die Kontaktbereiche 38a-d weisen jeweils Elektroden auf und sind ausgebildet, um einen elektrischen Kontakt mit an einer ersten Anschlagsfläche angeordneten Elektroden bereitzustellen. Die Kontaktbereiche 38a und 38b sind an Orten der Hauptscheitel der elliptischen Bahn angeordnet, so dass eine Hauptachse 34_4 der elliptischen Bahn zwischen den Kontaktbereichen 38a und 38b verläuft. Die Elektroden der Kontaktbereiche 38a und 38b bilden einen primären Kontaktbereich. Die Elektroden der Kontaktbereiche 38c und 38d bilden einen sekundären Kontaktbereich.

Die Elektroden in den Kontaktbereichen 38c und 38d sind an Orten der Nebenscheitel der elliptischen Bahn angeordnet, so dass eine Nebenachse 36_4 zwischen den Kontaktbereichen 38c und 38d verläuft. Die Hauptachse 34_4 und die Nebenachse 36_4 weisen ein Verhältnis von ungleich 1 auf. Das bedeutet, die Hauptachse 34_4 weist eine größere Länge auf als die Nebenachse 36_4. Die auslenkbare Aktuatorplatte 12_4 kann bspw. ausgebildet sein, um eine Hohlwölbung auszuführen. Basierend auf den unterschiedlichen Längen der Hauptachse 34_4 und der Nebenachse 36_4 ist die Hohlwölbung derart ausführbar, dass an Orten der Kontaktbereiche 38a und 38b der mechanischen Kontakt an der ersten Anschlagsfläche zu einem ersten Zeitpunkt bereitstellen und an Orten der Kontaktbereiche 38c und 38d der mechanische Kontakt zu einem zweiten Zeitpunkt bereitgestellt ist. Wird die auslenkbare Aktuatorplatte 12_4 beispielsweise aus einem ebenen Zustand in einen Zustand der Hohlwölbung versetzt, so kann der erste Zeitpunkt vor dem zweiten Zeitpunkt liegen. In anderen Worten schließen die Kontakte in den Kontaktbereichen 38c und 38d nach den Kontakten in den Kontaktbereichen 38a und 38b. Wird die auslenkbare Aktuatorplatte 12_4 aus einem Zustand, in dem sie die Hohlwölbung ausführt und in dem die mechanischen Kontakte bereitgestellt sind, in einen anderen, beispielsweise ebenen Zustand versetzt, so können sich die Kontakte in den Kontaktbereichen 38c und 38d zuerst und die Kontakte in den Kontaktbereichen 38a und 38b danach öffnen.

Alternativ können die Kontaktbereiche auch innerhalb eines in einem Toleranzbereich um die ellipsenförmige Bahn herum angeordnet sein, der durch Parallelverschiebungen derselben bestimmt ist. Die Parallelverschiebung kann einen Wert von weniger als ±25 %, weniger als ±15 % oder weniger als ±5 % der Abmessung der Hauptachse 34_4 bzw. Nebenachse 36_4 aufweisen.

In anderen Worten kann die Hohlwölbung so ausgeführt werden, dass die vier Kontaktpaare der mechanischen Kontakte in den Kontaktbereichen 38a-d oder daran angeordnete Elektroden mit den jeweiligen Partnerelementen an den Anschlagsflächen zeitlich versetzt geschlossen werden. Beim Betätigen des Aktuators können zuerst die beiden entlang der Hauptachse und danach die beiden entlang der Nebenachse geschlossen werden. Das Öffnen der Kontaktpaare kann genau andersherum erfolgen. Dieses sequentielle Schließen und Öffnen mehrerer Kontaktpaare kann beispielsweise genutzt werden, um eine Lebensdauer des MEMS zu erhöhen, wenn das MEMS beispielsweise als ohmscher Schalter eingesetzt wird.

Die jeweiligen Kontaktkräfte können individuell dimensioniert werden, beispielsweise durch eine Positionierung der Kontaktflächen abseits der Scheitelpunkte.

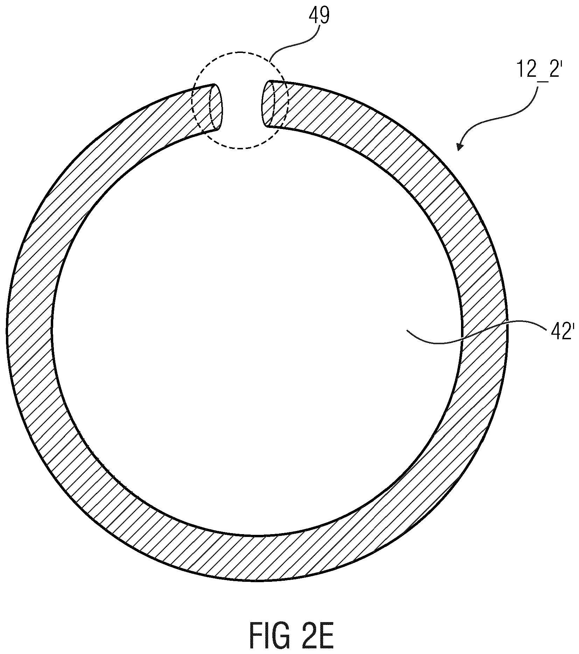

Fig. 2e zeigt eine schematische Aufsicht auf eine Hauptseite einer auslenkbaren Aktuatorplatte 12_2', die eine runde Form analog zu der auslenkbaren Aktuatorplatte 12_2 aus Fig. 2b aufweist. Eine Aussparung 42' ist gegenüber der Aussparung 42 vergrößert, so dass eine Breite des Ellipsenrings bspw. weniger als 30 %, weniger als 20 % oder weniger als 15 % einer Abmessung des Ellipsenrings in Richtung der Haupt- oder Nebenachse aufweisen kann.

Die Auslenkbare Aktuatorplatte 12_2' weist eine Aussparung 49 auf, so dass eine Ringform der auslenkbaren Aktuatorplatte 12_2' unterbrochen ist. Beispielsweise kann an einem Ort der Aussparung 49 ein Federelement oder ein Anker kontaktiert werden.

Alternativ können die auslenkbare Aktuatorplatten 12_1, 12_2, 12_2', 12_3 und/oder 12_4 eine andere bzw. beliebige Geometrie aufweisen, beispielsweise eine Hauptseitengeometrie mit einem polygonen, einem elliptischen, einem runden Umriss oder einem Umriss, mit entlang einer Kreisbahn äquidistant angeordneten Polygonen, elliptischen oder runden Formen. Basierend auf der Geometrie können sich eine Lage und eine Anzahl von zu erwartenden Kontaktpunkten, -bereichen und/oder -linien, in denen die von der auslenkbaren Aktuatorplatte generierte Kraft auf die Anschlagsfläche übertragen wird, ändern.

In anderen Worten zeigen die Figuren 2a-d verschiedene Aktuatorgeometrien und mögliche Kontaktbereiche mit einer ersten Anschlagsfläche, wenn die auslenkbare Aktuatorplatte die Hohlwölbung ausführt. Die Aktuatoren können am Rand und/oder mittig mit einer ersten oder einer zweiten Anschlagsfläche gekoppelt sein. Soll bspw. ein Kontakt zwischen einer auslenkbaren Aktuatorplatte und einer ersten Anschlagsfläche flächig gleichmäßig hergestellt werden, kann bevorzugt eine kreis- oder ringförmige Geometrie gewählt werden sein. Für ein ungleichmäßiges, beispielsweise zeitlich veränderliches Verhalten der mechanischen Kontakte kann eine elliptische Geometrie vorteilhaft sein. Alternativ sind auch Kombinationen aus ring-, kreis-, und/oder elliptischen Geometrien vorstellbar.

Eine Aktuatorplatte 12_1, 12_2, 12_3 und/oder 12_4 kann an beliebigen Stellen, etwa entlang der Kanten festgehalten werden. Die Anschlagsflächen können so dimensioniert werden, dass sie nur in den Bereichen vorhanden sind, in denen ein mechanischer Kontakt zu erwarten ist. Lage und Anzahl der Kontaktpunkte, -linien oder -flächen können von einer Geometrie der Aktuatorplatte 12_1, 12_2, 12_3 und/oder 12_4 und der jeweiligen Verankerung abhängen.

Vorteilhaft an diesem Ausführungsbeispiel ist, dass unterschiedliche Kontaktmaterialien von Elektroden an den Kontaktpaaren eingesetzt werden. Für das zuerst schließende, das heißt zuletzt öffnende Kontaktpaar umfassend die Kontakte in den Kontaktbereichen 38a und 38b, kann an den Elektroden beispielsweise ein hartes, widerstandsfähiges Material mit vergleichsweise hohem Kontaktwiderstand, wie etwa Wolfram, Chrom, Molybdän oder Kohlenstoff verwendet werden. Für Elektroden an dem zuletzt schließenden, das heißt zuerst öffnenden Kontaktpaar umfassend die Kontakte in den Kontaktbereichen 38c und 38d, können weichere, dafür einen geringeren Kontaktwiderstand aufweisende Materialien, wie etwa Gold oder Goldlegierungen angeordnet werden. Kontaktentladungen, (engl. micro arcs) während eines Öffnens oder Schließens von Elektrodenkontakten, die zu vielfältigen Alterungseffekten, wie etwa ein Verbrennen der Kontaktflächen führen können, können an dem zuerst geschlossenen, widerstandsfähigerem Kontaktpaar erfolgen. Die leitfähigeren, dafür empfindlicheren Kontakte, beispielsweise Goldkontakte, können dafür mit reduziertem oder ggf. ohne "micro arcing" geöffnet und/oder geschlossen werden. Auf diese Weise kann ein niedriger Kontaktwiderstand gewährleistet und gleichzeitig eine Lebensdauer bzw. eine Belastbarkeit des Schalters hinsichtlich einem Schalten unter Last, (engl. hot switching) erhöht werden.

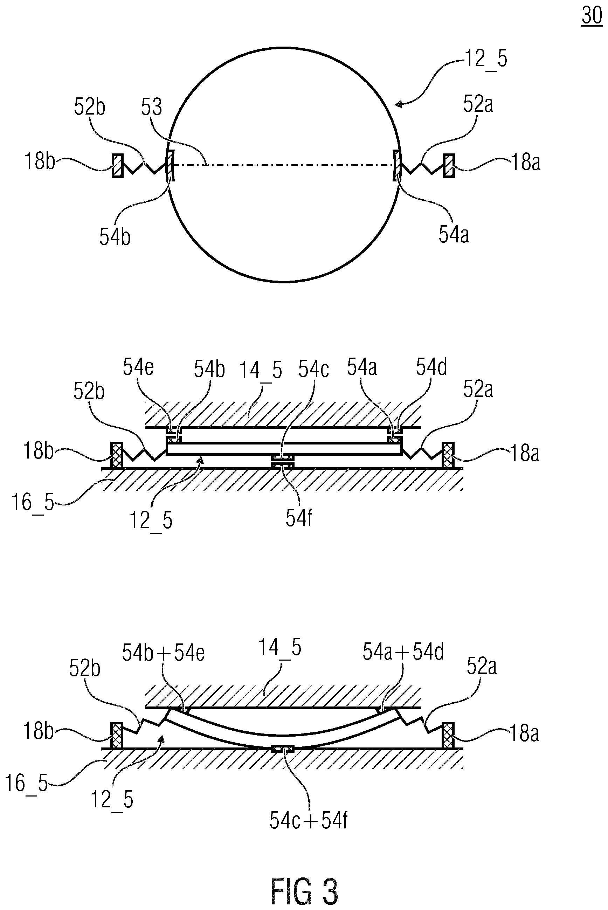

Fig. 3 zeigt in einem oberen Abschnitt eine schematische Aufsicht auf ein MEMS 30 mit einer auslenkbaren Aktuatorplatte 12_5, die über zwei Federelemente 52a und 52b an zwei Ankern 18a und 18b aufgehängt ist. Die Federelemente 52a und 52b sind entlang einer Achse 53 an der auslenkbaren Aktuatorplatte 12_5 angeordnet. Die Achse 53 kann beispielsweise eine Haupt- oder Nebenachse eines Ellipsenrings sein, dessen Fläche mit einer Fläche der piezoelektrischen Funktionsschicht überlappt. Die Federelemente können beispielsweise aus dem gleichen Material gebildet sein wie ein Substrat der auslenkbaren Aktuatorplatte 12_5, an welcher die piezoelektrische Funktionsschicht angeordnet ist. Die Federelemente 52a und 52b können mit dem Substrat einstückig gebildet sein. Dies kann beispielsweise durch einen Ätzvorgang während eines Herstellungsverfahrens des MEMS erfolgen. An der auslenkbaren Aktuatorplatte 12_5 sind benachbart zu den Federelementen 52a und 52b Elektroden 54a und 54b angeordnet. Die Federelemente 52a und 52b können prinzipiell eine beliebige Geometrie aufweisen. So können sie beispielsweise als Balkenfedern, Torsionsfedern und/oder Biegefedern ausgeführt sein.

In einem mittleren Abschnitt zeigt Fig. 3 das MEMS 30 in einer schematischen Seitenschnittansicht in einem Off-State. Basierend auf Federkräften der Federelemente 52a und 52b ist die auslenkbare Aktuatorplatte 12_5 beabstandet von einer ersten Anschlagsfläche 14_5 und einer zweiten Anschlagsfläche 16_5 angeordnet.

Elektrische Kontakte zwischen den Elektroden 54a und 54b und an der ersten Anschlagsfläche 14_5 angeordneten Elektroden 54d und 54e sind geöffnet. An einer der zweiten Anschlagsfläche 16_5 zugewandten Hauptseite der auslenkbaren Aktuatorplatte 12_5 ist eine Elektrode 54c angeordnet. An der zweiten Anschlagsfläche 16_5 ist eine Elektrode 54f der Elektrode 54c gegenüberliegend angeordnet und ausgebildet, um in dem On-State der auslenkbaren Aktuatorplatte 12_5 einen elektrischen Kontakt mit der Elektrode 54c zu bilden. Die Elektroden 54a-f sind Kontaktelektroden.

In einem unteren Abschnitt zeigt Fig. 3 eine schematische Seitenschnittansicht des MEMS 30 in dem On-State. Basierend auf der Hohlwölbung stellt die auslenkbare Aktuatorplatte 12_5 einen mechanischen Kontakt zu der ersten Anschlagsfläche 14_5 und zu der zweiten Anschlagsfläche 16_5 bereit. Die Federelemente 52a und 52b sind mit Ankern 18a und 18b verbunden, so dass die auslenkbare Aktuatorplatte 12_5 an Orten der Anker 18a bzw. 18b an der zweiten Anschlagsfläche 16_5 abgestützt ist.

In dem On-State ist neben dem mechanischen Kontakt auch ein elektrischer Kontakt zwischen den Elektroden 54a und 54d, 54b und 54e und 54c und 54f hergestellt. Damit kann beispielsweise ein elektrischer Kontakt zwischen der zweiten Anschlagsfläche 16_5 und der ersten Anschlagsfläche 14_5 bereitgestellt werden. Alternativ können die Elektroden 54a und/oder 54b sowie 54d und/oder 54e eine andere Form, bspw. eine ringförmige, aufweisen und ggf. unterschiedliche Radien der Elektroden 54a, 54b, 54d und oder 54e aufweisen.

In einem Volumen zwischen der ersten Anschlagsfläche 14_5 und der zweiten Anschlagsfläche 16_5 kann ein von einem Umgebungsdruck veränderter Druck bereitgestellt werden, beispielsweise ein erhöhter Luftdruck, ein durch Absaugen von Volumen generierter niedriger Luftdruck oder gar ein Luftdruck nahe des Vakuums. Alternativ kann auch ein von Luft oder Gas verschiedenes Medium angeordnet sein. Ein veränderter Druck oder eine gegenüber Luft veränderte Viskosität kann genutzt werden, um ein Schaltverhalten, etwa eine Schaltgeschwindigkeit oder eine Ausbreitung von Funken oder dergleichen zwischen öffnenden oder schließenden Elektroden des MEMS 30 zu beeinflussen.

In anderen Worten kann das Aufsetzen des Aktuators auf der unteren Grenzfläche eine Verkürzung des Hebels und eine Versteifung der Aktuatorstruktur bewirken, wobei der Moment des Aufsetzens durch den Abstand zwischen der oberen und der unteren Grenzfläche zumindest teilweise bestimmt werden kann. Bis unmittelbar vor dem Aufsetzen kann sich der Aktuator wie ein vergleichsweise langer und weicher Aktuator verhalten, mit dem sich größere Auslenkungen realisieren lassen, um ein Schließen des Kontaktes sicherzustellen. Im Moment des Aufsetzens verkürzt sich der Hebel schlagartig, so dass der Aktuator in Folge seiner erhöhten Federkonstante deutlich höhere Kräfte generiert. Durch das Aufsetzen können die Aktuatoren eine gegenüber einseitig eingespannten Balkenelementen verkürzte Einschaltzeit aufweisen. Zudem kann eine Anfälligkeit gegenüber Kontaktprellen (engl. contact bouncing) geringer sein als bei konventionellen Designs, etwa Biegebalken-Designs.

Eine weiche Verankerung des Aktuators mittels flexibler Federn kann eine Aktuator-Effizienz, das heißt eine erzeugte Kraft in Abhängigkeit von einer eingesetzten elektrischen Energie, hinsichtlich der Kraftgenerierung deutlich steigern, da bedingt durch die geringe Federkonstanten lediglich eine geringe Menge mechanischer Energie in den Federn gespeichert wird. Folglich kann ein Großteil der im Aktuator, beispielsweise dem Piezoelektrikum, generierte mechanische Energie für die Kraftgenerierung aufgewendet werden.

Vorteilhaft an diesem Ausführungsbeispiel ist, dass bspw. bei einer Aktuierung der auslenkbaren Aktuatorplatte 12_5 und beginnender Ausführung der Hohlwölbung ein Zeitpunkt existiert, in welchem ein mechanischer Kontakt zwischen der auslenkbaren Aktuatorplatte 12_5 und der zweiten Anschlagsfläche 16_5 bereitgestellt ist, etwa über den elektrischen Kontakt an den Elektroden 54c und 54f. Zu diesem Zeitpunkt kann sich eine Steifigkeit der auslenkbaren Aktuatorplatte 12_5 erhöhen, da gegenüber dem Zustand, wie er beispielsweise in dem mittleren Abschnitt dargestellt ist, ein weiterer Stützpunkt zwischen der auslenkbaren Aktuatorplatte 12_5 und der zweiten Anschlagsfläche 16_5 wirksam ist. Gegenüber dem Stützpunkt, wie er beispielsweise durch den Anker in der Fig. 1 bereitgestellt wird, kann diese Ausführungsform vorteilhaft sein, da ein Bereich, in welchem der Anker 18 in der Fig. 1 durch die feste Verbindung mit der auslenkbaren Aktuatorplatte 12 eine Auslenkung derselben behindert, reduziert sein kann. Alternativ oder zusätzlich können die Elektroden 54a-f und/oder die Achse 54 eine andere Position und/oder Ausrichtung bezüglich der auslenkbaren Aktuatorplatte 12_5 aufweisen.

Ferner ist vorteilhaft, dass basierend auf den Federelementen 52a und 52b, insbesondere wenn die Federelemente eine geringe Federsteifigkeit aufweisen, eine Behinderung der Auslenkung der auslenkbaren Aktuatorplatte 12_5 gegenüber einer Verankerung mittels eines Ankers reduziert oder verhindert werden. Weist ein Federelement eine hohe Federsteifigkeit auf, ist es also ein Starrkörper, so kann es als Anker angenähert oder bezeichnet werden.

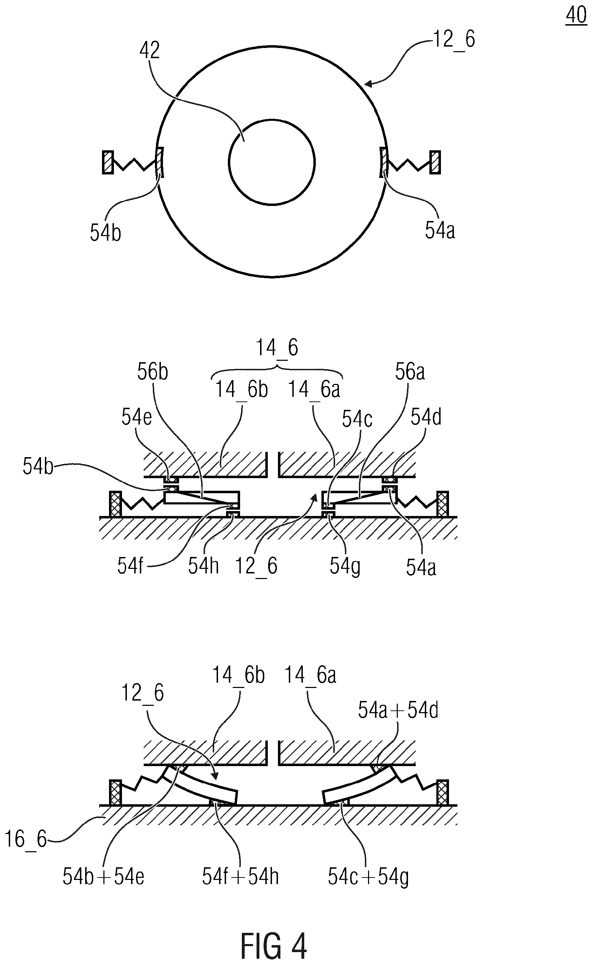

Fig. 4 zeigt eine schematische Ansicht eines MEMS 40, wobei das MEMS 40 in einem oberen Abschnitt der Fig. 4 in einer Aufsicht, in einem mittleren Abschnitt der Fig. 4 in einer schematischen Seitenschnittansicht in einem Off-State, und in einem unteren Abschnitt in einem On-State. Im Unterschied zu dem MEMS 30 in Fig. 3 weist die auslenkbare Aktuatorplatte 12_6 die innere Aussparung 42 auf.

Ferner weist eine Anschlagsfläche 14_6 einen ersten Teilbereich 14_6a und einen zweiten Teilbereich 14_6b auf, die beabstandet voneinander angeordnet sind. Die auslenkbare Aktuatorplatte 12_6 weist Elektroden 54a, 54c, 54b und 54f auf, wobei die Elektroden 54a und 54c sowie die Elektroden 54b und 54f über Schaltungsstrukturen 56a bzw. 56b miteinander verbunden sind. Wie es in dem unteren Abschnitt der Fig. 4 dargestellt ist, kann in dem Zustand, in dem die auslenkbare Aktuatorplatte den mechanischen und mithin den elektrischen Kontakt zu der ersten Anschlagsfläche 14_6 bereitstellt, mittels der Kontaktpaare 54c+54g und 54a+54d ein elektrischer Kontakt zwischen der zweiten Anschlagsfläche 16_6 und dem ersten Teilbereich 14_6a und ein weiterer elektrischer Kontakt zwischen der zweiten Anschlagsfläche 16_6 und dem zweiten Teilbereich 14_6b bereitstellbar sein, so dass das MEMS 40, wenn es als elektrischer Schalter eingesetzt wird, beispielsweise als dreipoliger Schalter nutzbar ist. Alternativ können an der zweiten Anschlagsfläche 16_6, an der ersten Anschlagsfläche 14_6 und/oder an der auslenkbaren Aktuatorplatte 12_6 weitere Kontakte angeordnet sein, so dass ein mehrpoliger elektrischer Kontakt herstellbar ist. Alternativ kann, etwa bei einer Abwesenheit der Elektroden 54c, 54g, 54f und 54h, ein elektrischer Kontakt zwischen den Elektroden 54d und 54e an dem ersten Teilbereich 14_6a und dem zweiten Teilbereich 14_6b hergestellt werden, wenn die auslenkbare Aktuatorplatte 12_6 Schaltungsstrukturen zwischen den Elektroden 54a und 54b aufweist und die Hohlwölbung ausführt.

Alternative Ausführungsbeispiele zeigen MEMS mit einer Anzahl von einem, zwei oder mehreren Teilbereichen der ersten oder zweiten Anschlagsfläche.

In anderen Worten zeigt Fig. 4 eine ringförmige Variante des an Federn aufgehängten Aktuators. Alternativ oder zusätzlich können Federelemente sowohl am äußeren Rand als auch am inneren Rand der Aktuatorplatte befestigt sein. Sind die Federn sehr weich und ist das Gap, das heißt der Abstand, zwischen der ersten Anschlagsfläche 14_6 und der zweiten Anschlagsfläche 16_6 entsprechend dimensioniert, kann die Aktuatorstruktur, das heißt die auslenkbare Aktuatorplatte 12_6 bei Betätigung, das heißt bei Ausführen der Hohlwölbung mit dem äußeren Rand gegen die erste Anschlagsfläche und mit dem inneren Rand gegen die zweite Anschlagsfläche 16_6 drücken. Mit einer Erhöhung der Federsteifigkeiten, das heißt sind die Federn härter ausgeführt, kann die entsprechende Kante unter Umständen ganz oder teilweise von der jeweiligen Anschlagsfläche, das heißt Begrenzungsfläche beabstandet bleiben. Eine Anzahl und Orientierung der Kontaktstellen zwischen der auslenkbaren Aktuatorplatte und den Begrenzungsflächen, das heißt Anschlagsflächen, kann von einer Form der auslenkbaren Aktuatorplatte abhängen.

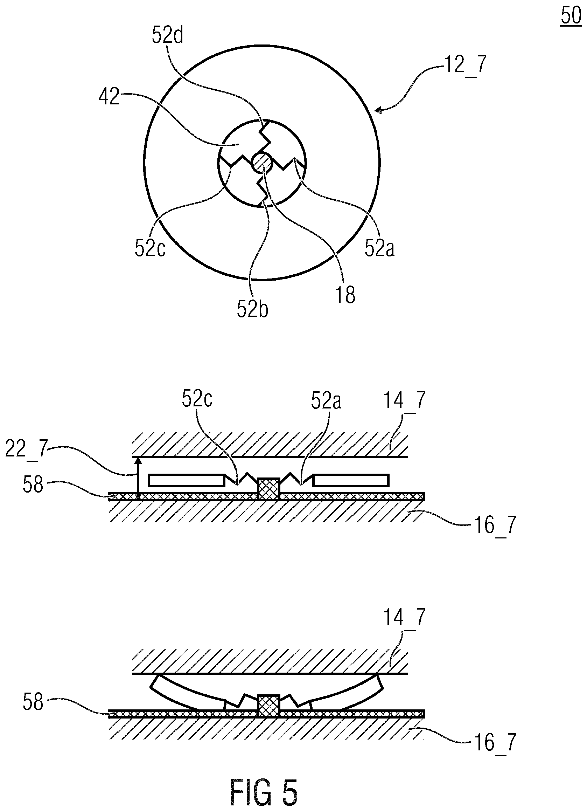

Fig. 5 zeigt schematische Ansichten eines MEMS 50, wobei die Fig. 5 in einem oberen Abschnitt eine Aufsicht auf eine auslenkbare Aktuatorplatte 12_7, in einem mittleren Abschnitt eine schematische Seitenschnittansicht des MEMS 50 in einem Off-State, und in einem unteren Abschnitt eine schematische Seitenschnittansicht des MEMS 50 in einem On-State. Die auslenkbare Aktuatorplatte 12_7 weist die Aussparung 42 auf. Die auslenkbare Aktuatorplatte 12_7 ist über vier Federelemente 52a-d mit dem Anker 18 verbunden, der in einem Mittelpunktbereich der Aussparung 42 bzw. der auslenkbaren Aktuatorplatte 12_7 angeordnet ist. Dies ermöglicht, dass die Federelemente 52a-d äquidistant an einer inneren Mantelfläche der auslenkbaren Aktuatorplatte 12_7, die durch die Aussparung 42 definiert ist, angeordnet sind und eine in etwa gleiche Länge aufweisen. Alternativ kann der Anker 18 auch an einer anderen Stelle angeordnet sein und/oder die Federelemente 52a-d einen Winkel von ungleich ≠ 90° zueinander aufweisen. Alternativ oder zusätzlich können die Federelemente 52a-d eine voneinander verschiedene Federsteifigkeit aufweisen und/oder an einem anderen Ort an der auslenkbaren Aktuatorplatte 12-7 angeordnet sein. Alternativ kann die auslenkbare Aktuatorplatte 12_7 mit einer von vier verschiedenen Anzahl von Federelementen an einer Anschlagsfläche oder an einem oder mehreren Ankerpunkten angeordnet sein.

Wie es in dem mittleren und dem unteren Abschnitt der Fig. 5 gezeigt ist, weist das MEMS 50 eine Statorelektrode 58 auf, die an der zweiten Anschlagsfläche 16_7 der auslenkbaren Aktuatorplatte 12_7 flächig gegenüberliegend angeordnet ist. Ein Anlegen einer elektrischen Spannung zwischen der Statorelektrode 58 und einer oder mehreren Elektroden, die an oder in der auslenkbaren Aktuatorplatte 12_7 angeordnet sind, ermöglicht eine Bereitstellung eines elektrostatischen Feldes zwischen diesen Elektroden, so dass eine Anziehungskraft zwischen der auslenkbaren Aktuatorplatte 12_7 und der zweiten Anschlagsfläche 16_7 bereitstellbar ist. Bspw. kann die elektrische Spannung zwischen der Statorelektrode 58 und einer Elektrode, die an der piezoelektrischen Funktionsschicht angeordnet ist, etwa die Elektrode 26a oder 26b in Fig. 1c oder einer äußeren Elektrode, bspw. die Elektrode 54c, anlegbar sein. Die Anziehungskraft kann größer sein als eine Haltekraft, die durch die Federelemente 52a-d bereitgestellt ist, so dass ein mechanischer Kontakt zwischen der zweiten Anschlagsfläche 16_7 und der auslenkbaren Aktuatorplatte 12_7 in dem Off-State bereitstellbar ist.

Verformungskräfte in der auslenkbaren Aktuatorplatte 12_7, die zu der Hohlwölbung führen, können größer sein als die Haltekräfte, die durch das elektrische Feld bereitgestellt werden. Alternativ oder zusätzlich kann die Statorelektrode 58 lediglich Teilbereichen der auslenkbaren Aktuatorplatte 12_7 gegenüberliegend angeordnet sein, so dass die Anziehungskraft lediglich in den Teilbereichen bereitgestellt werden.

Alternativ kann die Statorelektrode 58 auch an der ersten Anschlagsfläche 14_7 angeordnet sein, etwa wenn das Ausführen der Hohlwölbung zu einer Reduzierung von Kontaktflächen zwischen der ersten Anschlagsfläche 14_7 und der auslenkbaren Aktuatorplatte 12_7 führt, also die Hohlseite der zweiten Anschlagsfläche 16_7 zugewandt ist.

In anderen Worten ermöglicht eine weiche Aufhängung über äußere und/oder innere Federelemente, die bewegliche Aktuator-Struktur, die auslenkbare Aktuatorplatte im Off-State mittels elektrostatischer Kräfte flach und/oder auf die gegenüberliegende Begrenzungsfläche, das heißt Anschlagsfläche, zu ziehen, um einen ungewollten Kontakt nach oben hin zu verhindern bzw. den erforderlichen Abstand zwischen den Kontakten eines ohmschen Schalters zu gewährleisten. Dies kann insbesondere in Hochfrequenzanwendungen zu Vorteilen führen.

Vorteilhaft an dieser Ausführungsform ist, dass basierend auf der Anziehungskraft ein Abstand zwischen der ersten Anschlagsfläche 14_7 und der auslenkbaren Aktuatorplatte 12_7 definierbar, bspw. maximierbar sein kann. Die Anziehungskraft ermöglicht, dass die Hohlwölbung ausgehend von definierten Abständen (etwa in einem ebenen Zustand) zwischen der auslenkbare Aktuatorplatte 12_7 und der ersten Anschlagsfläche 14_7 ausführbar ist, da die auslenkbare Aktuatorplatte mittels der Anziehungskraft einen maximalen oder minimalen Abstand zu einer gegenüberliegenden Anschlagsfläche aufweisen kann, wenn die Aktuatorplatte die Hohlwölbung nicht ausführt. Dies kann eine exakte Berechnung und/oder Einhaltung von Schaltzeiten zwischen dem Off-State und dem On-State ermöglichen, da ein mittels der Hohlwölbung zu überbrückender Abstand zu der ersten Anschlagsfläche 14_7 reproduzierbar und konstant ist.

Bei einer Abwesenheit der Anziehungskraft kann, beispielsweise aufgrund von Temperatureffekten und/oder thermischer Ausdehnung ein Ausgangszustand, das heißt ein anfänglicher Abstand zwischen der auslenkbaren Aktuatorplatte 12_7 und der ersten Anschlagsfläche 14_7 und mithin eine Schaltzeit veränderlich sein. Alternativ oder zusätzlich kann basierend auf der Anziehungskraft ein zufälliger oder ungewollter mechanischer Kontakt zwischen der auslenkbaren Aktuatorplatte 12_7 und der ersten Anschlagsfläche 14_7 verhindert werden, etwa wenn das MEMS 50 erschüttert wird, so dass in dem Zustand, in dem die auslenkbare Aktuatorplatte 12_7 beabstandet von der ersten Anschlagsfläche 14_7 ist, ein ungewollter Kontakt hergestellt wird.

In anderen Worten zeigen Fig. 4 und Fig. 5 schematische Querschnitte durch ringförmige Aktuatoren, die innen bzw. außen mittels Federn flexibel verankert sind und Draufsichten auf die jeweiligen Platten mit den Verankerungselementen. Die Figuren 4 und 5 zeigen ringförmige Varianten eines an Federn aufgehängten Aktuators. Die Federn 52a-d können sowohl am äußeren als auch am inneren Rand der Aktuatorplatte befestigt sein. Sind die Federn 52a-d beispielsweise sehr weich und ist das Gap, d.h. ein Abstand zwischen den Anschlagsflächen 14_6 bzw. 14_7 und 16_6 bzw. 16_7 entsprechend dimensioniert, drückt die Aktuatorstruktur bei Betätigung in beiden Fällen mit dem äußeren Rand gegen die obere 14_6 bzw. 14_7 und mit dem inneren Rand gegen die untere Begrenzungsfläche (Anschlagsfläche) 16_6 bzw. 16_7. Weisen die Federn 52a-d eine sehr hohe oder näherungsweise unendlich große Steifigkeit auf, können sie bezüglich ihres Verhaltens durch Ankerpunkte bzw. Anker angenähert werden. Eine Lage und eine Anzahl von Kontaktpunkten und Befestigungsarten, das heißt Federn 52a-d und/oder Anker, mit den Begrenzungsflächen, das heißt Anschlagsflächen, kann von einer Form der jeweiligen auslenkbaren Aktuatorplatte abhängen.

In anderen Worten ist an diesem Ausführungsbeispiel vorteilhaft, dass im Vergleich zu fest verankerten Strukturen, wie es beispielsweise in der Fig. 1 gezeigt ist, der Aktuator im Ruhezustand durch Anlegen einer Spannung auf das Substrat, das heißt die zweite Anschlagsfläche 16_7 heran- bzw. heruntergezogen werden kann. Dies kann als elektrostatische Klemmung (engl. electrostatic clamping) bezeichnet werden. Dadurch kann stets ein erforderlicher Mindestabstand zwischen den Kontaktflächen eines Kontaktpaares oder zwischen der auslenkbaren Aktuatorplatte und der ersten Anschlagsfläche gewährleistet werden, unabhängig von prozessbedingten oder thermisch induzierten Variationen des Stresses im Aktuatorstack.

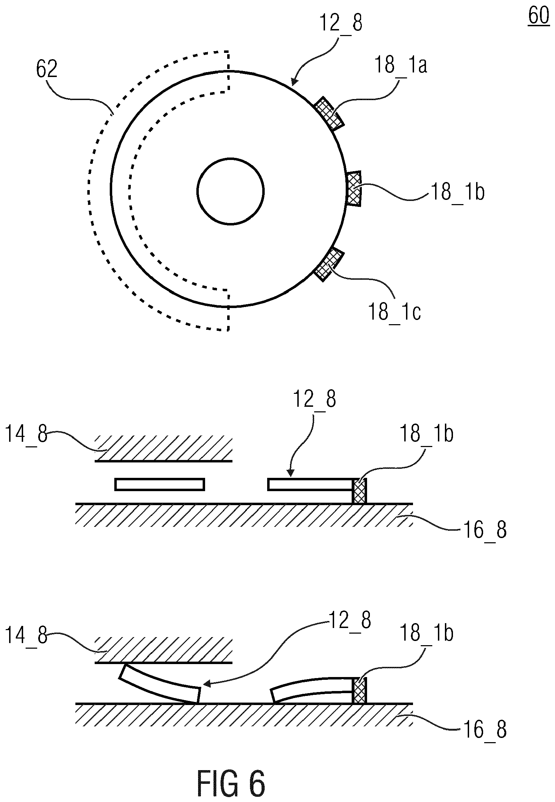

Fig. 6 zeigt eine schematische Darstellung eines MEMS 60 mit einer auslenkbaren Aktuatorplatte 12_8, die mittels drei Ankern 18_1a, 18_1b und 18_1c mit einer zweiten Anschlagsfläche 16_8 verbunden ist.

In einem oberen Abschnitt zeigt Fig. 6 die auslenkbare Aktuatorplatte 12_8, die Ankerpunkte 18_1a-c sowie einen Bereich 62, in dem eine erste Anschlagsfläche 14_8, die in einem mittleren und einem unteren Abschnitt der Fig. 6 dargestellt ist, angeordnet ist. Die Anker 18_1a-c sind an einer Hälfte einer Hauptseite der auslenkbaren Aktuatorplatte 12_8 angeordnet, die dem Bereich 62 gegenüberliegend angeordnet ist. Basierend auf der einseitigen, d.h. in einer Hälfte der Hauptseite angeordneten, festen Einspannung kann die auslenkbare Aktuatorplatte 12_8 so ausgebildet sein, dass die Hohlwölbung an der Halbseite, an der die Anker 18_1a-c angeordnet sind, zumindest teilweise unterdrückt ist. An der Halbseite, in der der Bereich 62 bzw. die erste Anschlagsfläche 14_8 angeordnet ist, kann der Kontakt zwischen der auslenkbaren Aktuatorplatte 12_8 und der ersten Anschlagsfläche 14_8 bereitgestellt werden.

Wenn die Verankerungspunkte, das heißt Anker 18_1a-c rotationsasymmetrisch angeordnet sind, können die Kontaktpunkte, das heißt der Kontaktbereich ebenfalls asymmetrisch angeordnet sein. Zum Kontakt mit der ersten Anschlagsfläche 14_8 kann es beispielsweise auf der Seite, die den Ankerpunkten 18_1a-c abgewandt ist, kommen, beispielsweise der linken Seite in Fig. 6. Die auslenkbare Aktuatorplatte 12_8 bildet im unteren Abschnitt der Fig. 6 einen Kontakt mit der zweiten Anschlagsfläche 16_8.

In anderen Worten müssen in den Bereichen, in denen die Begrenzungsflächen 14_8 und 16_8 von der auslenkbaren Aktuatorplatte 12_8 in einem On-State oder Off-State nicht berührt werden, auch nicht unbedingt vorhanden sein.

Im mittleren und unteren Abschnitt zeigt Fig. 6 schematisch einen ringförmigen Aktuator, der entlang der Kanten an einzelnen Punkten fest verankert ist. In einem oberen Abschnitt zeigt Fig. 6 eine Draufsicht auf die Platte 12_8 mit den Verankerungselementen 18_1a-c und dem Bereich 62, in dem die erste Anschlagsfläche 14_8 angeordnet ist.

Alternativ kann die auslenkbare Aktuatorplatte 12_8 mit einer von drei verschiedenen Anzahl von Ankern an einer Anschlagsfläche angeordnet sein und/oder eine auslenkbare Aktuatorplatte mit einer geschlossenen, d.h. ununterbrochenen Hauptseitengeometrie sein, bspw. die auslenkbare Aktuatorplatte 12.

Vorteilhaft an diesem Ausführungsbeispiel ist, dass eine Ausdehnung der ersten Anschlagsfläche 14_8 reduziert sein kann. Dies ermöglicht beispielsweise Materialeinsparungen bezüglich der ersten Anschlagsfläche 14_8. Ferner kann die auslenkbare Aktuatorplatte 12_8 in dem Zustand, in dem die Hohlwölbung ausgeführt wird, durch die einseitige Verankerung verkippen. Hierdurch können sich Auslenkung und Kraft auf der freien Seite erhöhen. Darüber hinaus kann infolge des Aufsetzens auf der unteren Anschlagsfläche 16_8 zu einer Hebelwirkung auftreten. Ein weiterer Vorteil liegt darin, dass eine Fläche des Kontaktbereichs zur oberen Anschlagsfläche 14_8 kleiner als in vorangegangenen Ausführungsbleispielen sein kann. Gegenüber Strukturen, wie etwa MEMS 10 mit Kontakte mehr als einer Seite, kann eine Kontaktkraft erhöht sein, da die Auslenkung des Aktuators an der anderen Seite eingeschränkt oder unterdrückt wird und die Kontaktkraft an der jeweils anderen (freien) Seite bereitgestellt werden kann.

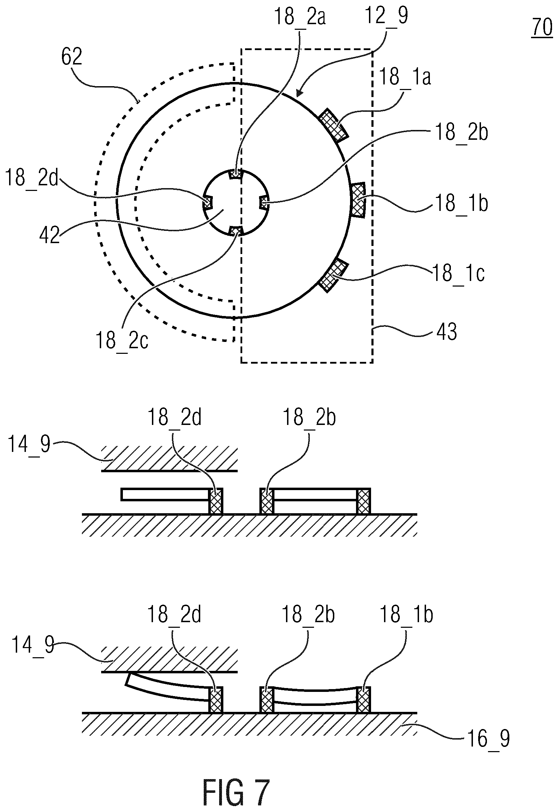

Fig. 7 zeigt schematische Ansichten eines MEMS 70, das eine auslenkbare Aktuatorplatte 12_9 aufweist, das gegenüber dem MEMS 60 aus Fig. 6 zusätzlich an einer durch die Aussparung 42 definierten inneren Mantelfläche der auslenkbaren Aktuatorplatte 12_9 durch vier innere Ankerpunkte 18_2a-d fixiert ist. Eine Hohlwölbung der auslenkbaren Aktuatorplatte 12_9 kann basierend auf der Einspannung mittels der Anker 18_2a-d gegenüber einer Auslenkung, wie sie in Fig. 6 dargestellt ist, reduziert sein. In einer Halbebene bzw. Halbseite 43, in welcher die Anker 18_1a-c angeordnet sind, kann ein mechanischer Kontakt zwischen der auslenkbaren Aktuatorplatte 12_9 basierend auf der Einspannung und der zweiten Anschlagsfläche 16_9 verhindert sein. Alternativ kann der Kontakt zwischen der auslenkbaren Aktuatorplatte 12_9 und der zweiten Anschlagsfläche 16_9 auch bereitstellbar sein, etwa wenn die Hohlwölbung zu einer Durchbiegung mit entsprechend starker Amplitude führt, oder wenn ein Abstand, der durch die Anker 18_1a-c und/oder 18_2a-d zwischen der auslenkbaren Aktuatorplatte 12_9 und der zweiten Anschlagsfläche 16_9 gegenüber der Darstellung in Fig. 7 reduziert ist.

Alternativ kann die auslenkbare Aktuatorplatte 12_9 mit einer von vier verschiedenen Anzahl von Ankern an der inneren Mantelfläche aufgehängt sein.

In anderen Worten zeigen die Figuren 6 und 7 Varianten fest verankerter Aktuatorstrukturen mit harten Federelementen (engl. rigid clamping) und schematische Querschnitte durch ringförmige Aktuatoren, die entlang der Kanten an einzelnen Punkten fest verankert sind sowie Draufsichten auf die jeweiligen Platten mit den Verankerungselementen und der oberen Begrenzungsfläche.

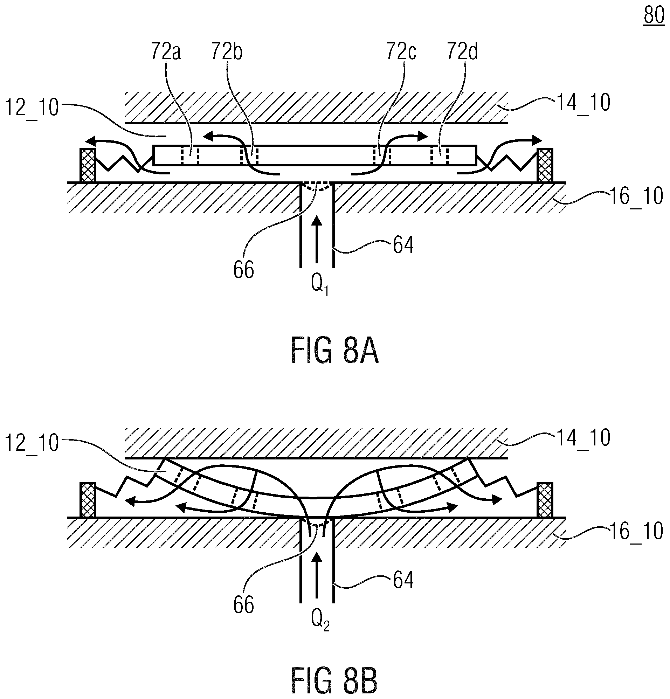

Fig. 8a zeigt eine schematische Seitenschnittansicht eines Mikroventils 80, das eine auslenkbare Aktuatorplatte 12_10 aufweist. Das Mikroventil 80 ist ein MEMS. Das Mikroventil 80 weist eine Fluidleitung 64 auf, die ausgebildet ist, um ein Fluid, etwa ein Gas oder eine Flüssigkeit, in einen Bereich zwischen einer ersten Anschlagsfläche 14_10 und einer zweiten Anschlagsfläche 16_10 zu leiten. Die zweite Anschlagsfläche 16_10 weist einen Fluidzulauf 66 auf, der ausgebildet ist, um das Fluid in den Bereich zwischen der ersten Anschlagsfläche 14_10 und 16_10 passieren zu lassen. Die auslenkbare Aktuatorplatte 12_10 weist Öffnungen, d.h. Release Holes, 72a-d auf, die ausgebildet sind, durch die das Fluid passieren kann. Die auslenkbare Aktuatorplatte 12_10 ist bezüglich des Fluidzulaufs 66 so angeordnet, dass in einem Off-State des Mikroventils 80 ein Volumenstrom Q₁ durch die Fluidleitung 64 transportierbar ist. Das Fluid kann das Mikroventil 80 durch einen Bereich zwischen der auslenkbaren Aktuatorplatte 12_10 und der zweiten Anschlagsfläche 16_10 verlassen und ferner die auslenkbare Aktuatorplatte 12_10 durch die Release Holes 72a-d passieren und das Mikroventil 80 durch einen Zwischenraum zwischen der ersten Anschlagsfläche 14_10 und der auslenkbaren Aktuatorplatte 12_10 verlassen.

Fig. 8b zeigt das Mikroventil 80 in einem On-State. Basierend auf der Hohlwölbung der auslenkbaren Aktuatorplatte 12_10 ist der Fluidzulauf 66 zumindest teilweise von der auslenkbaren Aktuatorplatte 12_10 verschlossen, so dass ein Volumenstrom Q₂ durch die Fluidleitung 64 transportierbar ist. Der Volumenstrom Q₂ kann geringer sein als der Volumenstrom Q₁. Beispielsweise kann die auslenkbare Aktuatorplatte 12_10 den Fluidzulauf 66 auch vollständig verschließen, so dass der Volumenstrom Q₂ einen Wert von 0 oder nahe 0 aufweist.

Das Mikroventil 80 weist eine Konfiguration auf, die auch als "Schließer" oder dem englischen Begriff "normally on", d.h. "Normalzustand an", bezeichnet werden kann. Das bedeutet, dass das Mikroventil 80 in einem unaktuierten Zustand der auslenkbaren Aktuatorplatte 12_10 einen Durchfluss des Fluids mit dem Fluidstrom Q₂ ermöglicht.

Alternativ kann das Mikroventil 80 auch so ausgeführt sein, dass der Fluidzufluss 66 in dem Off-State von der auslenkbaren Aktuatorplatte 12_10 zumindest teilweise verschlossen ist. Das bedeutet, dass eine Aktuierung der auslenkbaren Aktuatorplatte 12_10 zu einem vergrößerten Volumenstrom des Fluids führen kann. Diese Konfiguration kann als "Normalzustand aus" (engl. "normally off') oder als "Öffner" bezeichnet werden.

Alternativ kann die auslenkbare Aktuatorplatte 12_10 auch vollständig geschlossene Hauptoberflächenbereiche aufweisen, so dass ein Fluidfluss durch (abwesende) Release Holes verhindert ist.

In anderen Worten kann bei einem Kontakt zwischen dem Aktuator und der unteren Begrenzungsfläche die Öffnung des Fluidzuflusses oder eines Fluidabflusses vollständig umschlossen sein.

Alternativ kann die auslenkbare Aktuatorplatte 12_10 auch eine mittige Öffnung, etwa die Öffnung 42, aufweisen. In Fig. 8b könnte in diesem Fall der Fluidstrom Q₂ durch den Fluidzufluss in einen Bereich zwischen der ersten Anschlagsfläche 14_10 und der auslenkbaren Aktuatorplatte 12_10 fließen. Bei einer Abwesenheit der Release Holes 72a-d könnte dann der Fluidstrom Q₂ aus diesem Bereich austreten. Alternativ könnte ein Austritt eines Fluidstroms aus diesem Bereich basierend auf den Kontaktkräften zwischen der ersten Anschlagsfläche 14_10 und der auslenkbaren Aktuatorplatte 12_10 auch verhindert sein.

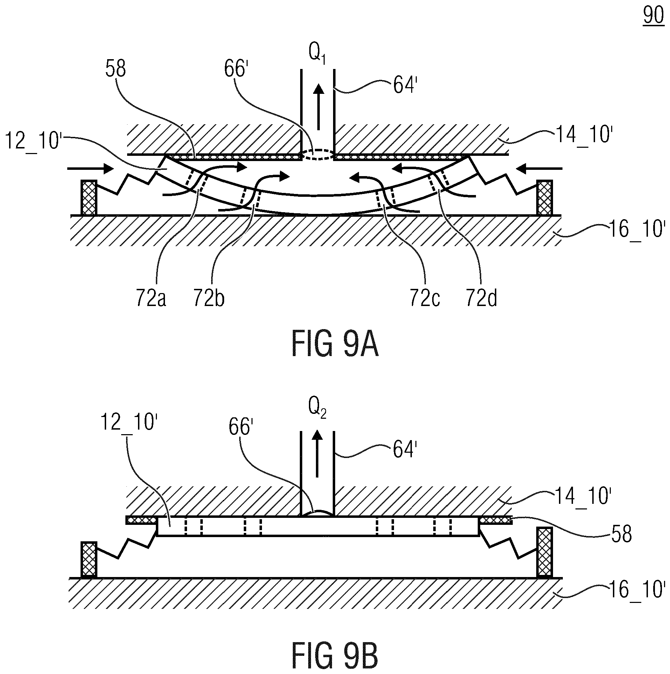

Fig. 9a zeigt ein Mikroventil 90 mit einer auslenkbaren Aktuatorplatte 12_10' in dem Zustand, in dem die auslenkbare Aktuatorplatte 12_10' die Hohlwölbung ausführt. Das Mikroventil 90 weist ferner einen Fluidablauf 66' auf, der an einer ersten Anschlagsfläche 14_10' angeordnet ist und einen Austritt des Fluids mit dem Volumenstrom Q₁ durch eine Fluidleitung 64' ermöglicht.

Fig. 9b zeigt das Mikroventil 90 in einem Zustand, in welchem die auslenkbare Aktuatorplatte 12_10' einen ebenen Zustand aufweist. An der Anschlagsfläche 14_10' ist die Statorelektrode 58 angeordnet, so dass die auslenkbare Aktuatorplatte 12_10' mittels Anziehungskräften an die erste Anschlagsfläche 14_10' gezogen werden kann.

Basierend auf der Anziehungskraft ist der Fluidablauf 66' verschlossen, so dass der gegenüber dem Fluidstrom Q₁ reduzierte Fluidstrom Q₂ durch die Fluidleitung 64' fließen kann. Diese Konfiguration kann als "normally off' bezeichnet werden.

Alternativ kann eine Richtung des Fluidflusses auch umgekehrt werden, so dass der Fluidablauf 66' ein Fluidzulauf ist, beispielsweise der Fluidzulauf 66.

In anderen Worten zeigen die Fig. 9a und 9b eine Variante eines Mikroventils, bei der das Fluid hauptsächlich durch die release holes fließt.

Während das Mikroventil 80 ausgebildet ist, um einen das Selbige durchlaufenden Fluidstrom zu verringern, wenn die auslenkbare Aktuatorplatte 12_10 die Hohlwölbung ausführt, ist das Mikroventil 90 ausgebildet, um einen Fluidstrom zu verringern oder zu verhindern, wenn die auslenkbare Aktuatorplatte 12_10' eben ausgebildet ist oder die Hohlwölbung nicht oder nur teilweise ausführt.

Vorteilhaft an den Ausführungsbeispielen mit den Mikroventilen 80 oder 90 ist, dass basierend auf den Kontaktkräften des 'zwischen der auslenkbaren Aktuatorplatte 12_10 bzw. 12_10' Fluide oder Medien mit einem hohen Druck kontrollierbar sind, da die Kontaktkräfte dem Druck entgegenwirken können.

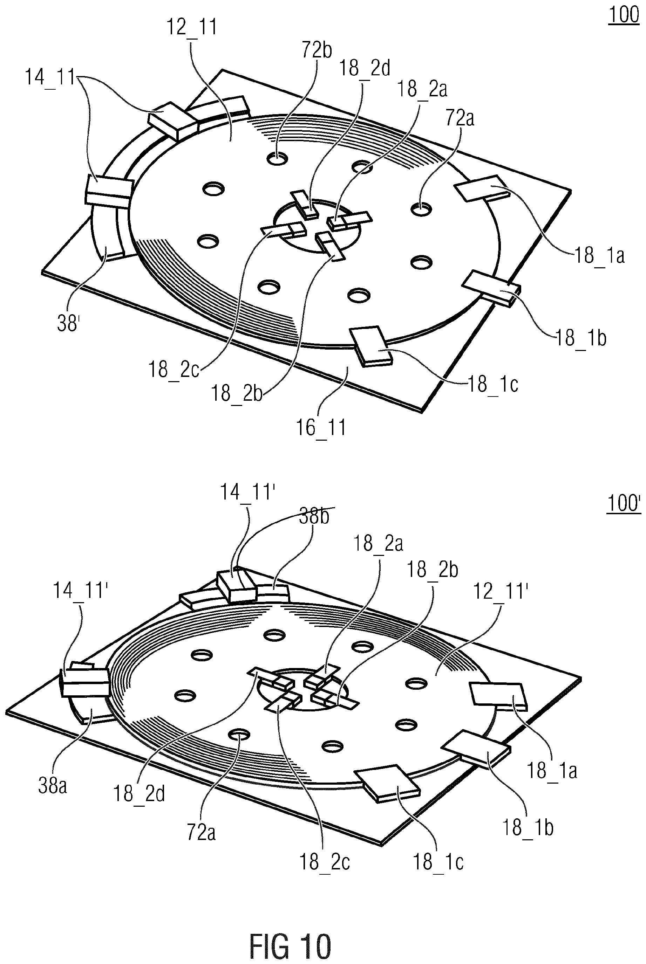

Fig. 10 zeigt in einer oberen Bildhälfte Ergebnisse eine schematische 3D-Ansicht eines MEMS 100 und in einer unteren Bildhälfte eine schematische 3D-Ansicht eines MEMS 100' in Form einer Finite-Elemente-Modulierung (FEM), die einen Aufbau aufweisen, wie er bspw. für MEMS 70 in der Fig. 7 beschrieben ist.

Eine auslenkbare Aktuatorplatte 12_11 bzw. 12_11' ist über einen inneren Ring von vier Ankern 18_2a-d an einer zweiten Anschlagsfläche 16_11 bzw. 16_11' angeordnet und über drei Anker 18_1_a-c ebenfalls mit der zweiten Anschlagsfläche 16_11 bzw. 16_11' angeordnet. MEMS 100' weist gegenüber MEMS 100 variierte Ankerpunkte auf. MEMS 100 bzw. 100' kann beispielsweise unter Verwendung Oberflächen-mikromechanischer Fertigungstechniken hergestellt werden. Die auslenkbare Aktuatorplatte 12_11 bzw. 12_11' kann beispielsweise durch Herausätzen einer darunter befindlichen Opferschicht freigestellt werden. Dafür können in der auslenkbaren Aktuatorplatte zusätzliche Öffnungen (engl. release holes) 72a und 72b angeordnet sein. Release holes ermöglichen eine Verringerung einer Unterätzdistanz. Als Unterätzdistanz kann eine Distanz verstanden werden, über welche eine Opferschicht von zwei für Ätzmittel zugänglichen Punkten ausgehend entfernt wird. Die Unterätzdistanz kann verglichen mit einer bei einer Abwesenheit von release holes von einem Randbereich der auslenkbaren Aktuatorplatte 12_11 oder 12_11' herausgeätzten Opferschicht verringert sein. Das bedeutet, dass durch die release holes 72a-b ein Abstand zwischen Orten, an denen ein Ätzmittel oder eine Ätzlösung zur Entfernung der Opferschichten eingebracht werden kann, reduziert wird.

Die zweite Anschlagsfläche 16_11 bzw. 16_11', in Fig. 10 die untere Begrenzungsfläche, kann dabei durch einen Siliziumwafer gebildet sein, wobei eine Dicke einer in Fig. 10 herausgelösten unteren Opferschicht zwischen der zweiten Anschlagsfläche 16_11 bzw. 16_11' und der auslenkbaren Aktuatorplatte 12_11 bzw. 12_11' einen ersten Teilabstand zwischen der ersten und der zweiten Anschlagsfläche 14_11 bzw. 14_11' und 16_11 bzw. 16_11' bestimmen kann, beispielsweise in einem Bereich von 0,1 bis 10, von 0,2 bis 5 oder von 0,5 bis 2 µm. Die erste Anschlagsfläche 14_11, in Fig. 10 die obere Begrenzungsfläche, kann beispielsweise durch starre Kontakte (engl. fixed contacts) oberhalb der auslenkbaren Aktuatorplatte 12_11 bzw. 12_11' gebildet werden und beispielsweise aus einem dicken Metall, beispielsweise 5, 10 oder 20 µm bestehen. "Oberhalb" der Aktuatorplatte 12_11 bzw. 12_11' bedeutet in diesem Zusammenhang eine der zweiten Anschlagsfläche 16_11 bzw. 16_11' abgewandte Hauptseite der auslenkbaren Aktuatorplatte 12_11 bzw. 12_11'. Auf der auslenkbaren Aktuatorplatte 12_11 bzw. 12_11' können in Kontaktbereichen 38' bzw. 38a und/oder 38b dazu passende, bewegliche Kontaktflächen (engl. movable contacts), beispielsweise aus Metall, angeordnet sein.

Die jeweiligen Kontaktpaare können bei einer Hohlwölbung der auslenkbaren Aktuatorplatte miteinander in Berührung kommen. Zur Herstellung der fixen, oberen Kontakte in der Anschlagsfläche 14_11 bzw. 14_11' kann beispielsweise eine weitere Opferschicht oberhalb der Aktuatorplatte angeordnet werden. Eine Summe von Dicken beider Opferschichten kann den Hub (gap), etwa den Abstand 22 in Fig. 1, zumindest teilweise bestimmen. Ist der Aktuator beispielsweise ein PZT-Aktuator, kann das Anlegen einer elektrischen Spannung an die auslenkbare Aktuatorplatte 12_11 bzw. 12_11' zu einer Längskontraktion derselben und mithin zum Ausführen der Hohlwölbung führen.

Die auslenkbare Aktuatorplatte 12_11 bzw. 12_11' weist beispielhaft einen Durchmesser von 130 µm auf. Die untere Opferschicht weist beispielhaft eine Dicke von 0,5 µm, die obere Opferschicht eine Dicke von 2 µm auf. In anderen Worten zeigt Fig. 10 Ergebnisse einer FEM-Simulation der Verwölbung eines ringförmigen Aktuators mit unterschiedlich verteilten Kontakt- bzw. Verankerungspunkten.

Die release holes 72a und 72b können beispielsweise genutzt werden, um Dämpfungseigenschaften basierend auf einer Aussparung in der auslenkbaren Aktuatorplatte 12_11 bzw. 12_11' zu beeinflussen.

Alternative Ausführungsbeispiele zeigen auslenkbare Aktuatorplatten mit einer längsten Abmessung zweier beliebiger Punkte einer Hauptseite und/oder einen Durchmesser mit einer Abmessung von mehr als 10 µm, mehr als 100 µm oder mehr als 1.000 µm.

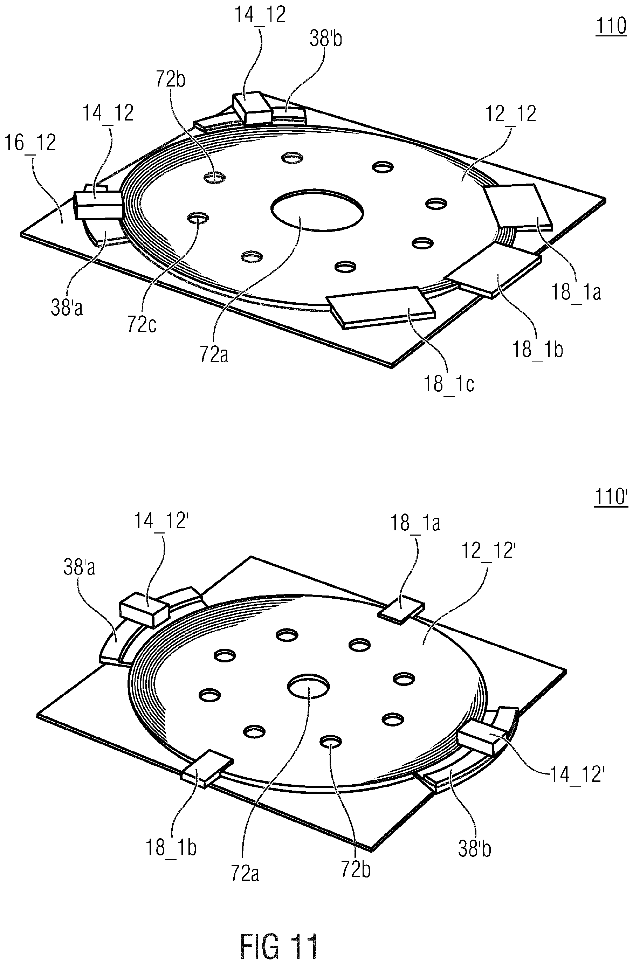

Fig. 11 zeigt in einer oberen Bildhälfte Ergebnisse von FEM-Berechnungen eines MEMS 110 bzw. in einer unteren Bildhälfte eines MEMS 110' mit einer Struktur analog dem MEMS 100 bzw. 100' bei einer Abwesenheit der inneren Verankerungspunkte, wie es in der Fig. 6 dargestellt ist. MEMS 110 und 110' weisen Kontaktbereiche 38'a und 38'b auf, die ausgebildet sind, um den mechanischen Kontakt mit deiner ersten Anschlagsfläche 14_12 bzw. 14_12' zu bilden. Eine auslenkbare Aktuatorplatte 12_12 bzw. 12_12' weist die release holes 72a, 72b und 72c auf, wobei das release hole 72a der Aussparung 42 in Fig. 4 entsprechen kann. MEMS 110' unterscheidet sich von MEMS 110 dadurch, dass die Anker 18_1-c des MEMS 110' paarweise gegenüber angeordnet sind, das heißt äquidistant an der äußeren Mantelfläche angeordnet sind. Wie es in der Fig. 6 dargestellt ist, kann die auslenkbare Aktuatorplatte in dem Zustand, in dem sie die Hohlwölbung ausführt, einen mechanischen Kontakt mit dem Substrat, das heißt der zweiten Anschlagsfläche aufweisen. Dadurch kann sich der effektive Hebel verkürzen.

In anderen Worten zeigt Fig. 11 eine FEM-Simulation der Verwölbung eines ringförmigen Aktuators ohne innere Verankerung mit unterschiedlich verteilten Kontakt- bzw. Verankerungspunkten.

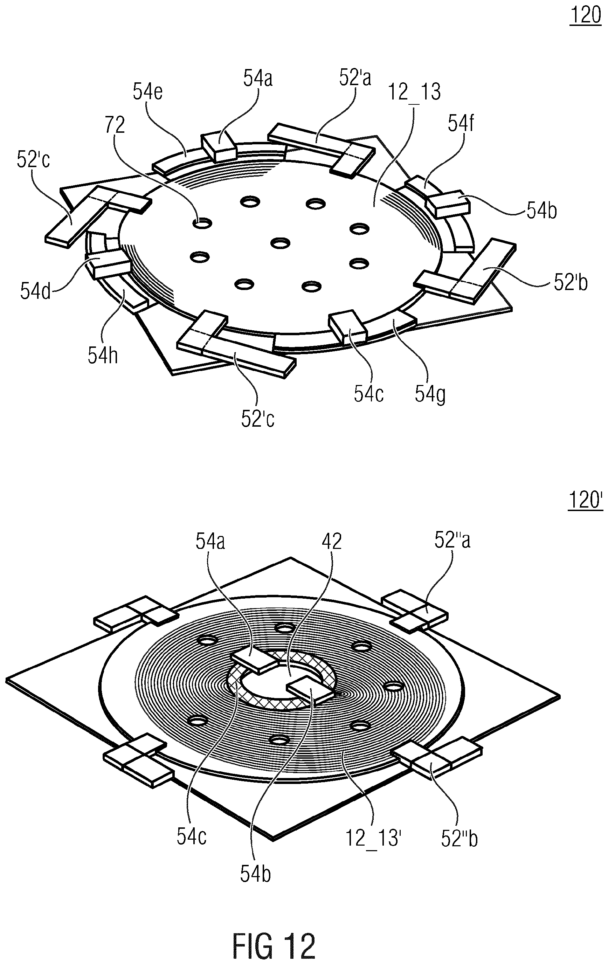

Fig. 12 zeigt in einer oberen Bildhälfte eine schematische dreidimensionale Ansicht eines MEMS 120 und in einer unteren Bildhälfte eine schematische dreidimensionale Ansicht eines MEMS 120'. Das MEMS 120 weist eine auslenkbare Aktuatorplatte 12_13 mit release holes 72 auf und ist mittels vier Federelementen 52'a-d an einem nicht-dargestellten Substrat aufgehängt. Die Federelemente 52'a-d können eine beliebige, insbesondere geringe Federsteifigkeit mit einem Wert von beispielsweise, wenigstens 0,01 N/m, 0,1 N/m oder 0,5 N/m und vorzugsweise weniger als 500 N/m oder 1.000 N/m oder 5000 N/m auf aufweisen.

Das MEMS 120' in der unteren Bildhälfte weist die innere Aussparung 42 auf. MEMS 120 verwölbt sich beispielsweise mit der Mitte nach oben und mit dem Rand nach unten. Die zu schließenden Kontaktbereiche bzw. -elektroden (54a-h) sind bei MEMS 120 an oder gegenüberliegend einem äußeren Bereich der auslenkbaren Aktuatorplatte 12_13 angeordnet, bei MEMS 120' sind die Elektroden 54a-c entlang des inneren Bereichs oder Randes angeordnet. MEMS 120 oder MEMS 120' kann beispielsweise mit einem MEMS 30, 40 oder 50 umsetzbar sein. Die innere Aussparung 42 kann genutzt werden, um eine Öffnung für das Herausätzen der Opferschichten bereitzustellen. Die Elektroden (engl. upper fixed contacts) 54a, 54b des MEMS 120' können beispielsweise mit dem Substrat, das heißt der ersten, nicht dargestellten, Anschlagsfläche verbunden sein.

In anderen Worten zeigt Fig. 12 eine FEM-Simulation der Verwölbung ringförmiger Aktuatoren, verankert mittels weicher Federn (engl. Weak spring-type anchoring) entlang des äußeren Randes und einen Aktuator gemäß der schematischen Darstellung in den Figuren 3 und 4. Die runde Aktuatorplatte ist entlang der äußeren Kante an flexiblen Federn aufgehängt, die nur am anderen Ende fest verankert sind. Bei einem Schließen der vier Kontaktpaare, ebenfalls entlang der äußeren Kante angeordnet, wird die Mitte der Aktuatorplatte gegen das Substrat heruntergepresst.

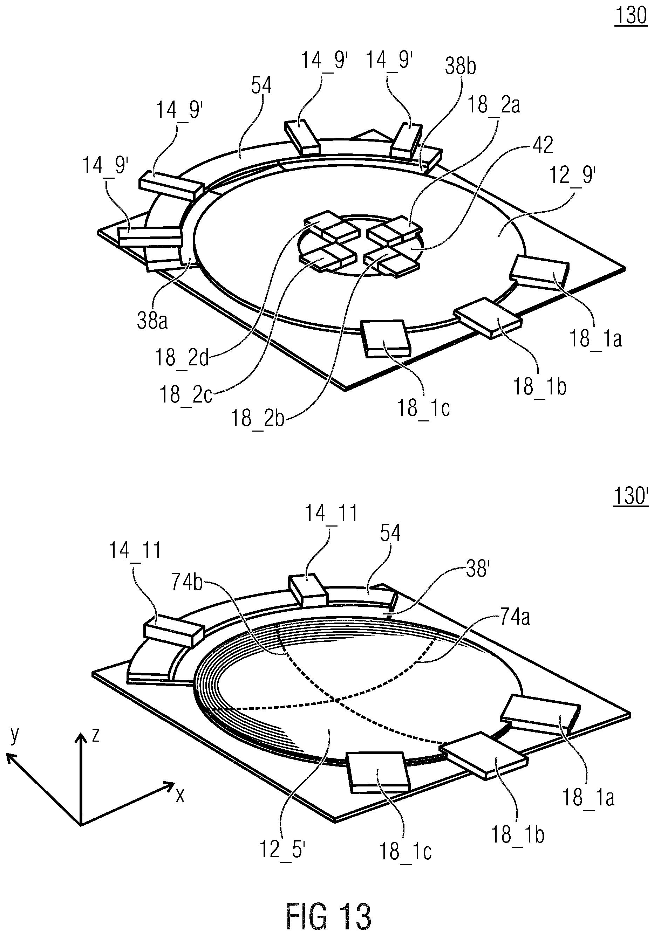

Fig. 13 zeigt in einer oberen Bildhälfte schematische Ergebnisse von FEM-Berechnungen eines MEMS 130 bzw. in einer unteren Bildhälfte eines MEMS 130'. Das MEMS 130 weist eine auslenkbare Aktuatorplatte 12_9' auf, die gegenüber der auslenkbaren Aktautorplatte 12_9 in Fig. 7 an einem äußeren Umfang der auslenkbaren Aktuatorplatte angeordnete Kontaktbereiche 38a und 38b aufweist, die über die an den Kontaktbereichen angeordnete gemeinsame bewegliche Elektrode 54 verbunden sind. Die gemeinsame bewegliche Elektrode 54 ist ausgebildet, um einen mechanischen und ggf. elektrischen Kontakt mit einer ersten Anschlagsfläche 14_9' zu ermöglichen.

Das MEMS 130' weist eine auslenkbare Aktuatorplatte 12_5' auf, die eine gegenüber der auslenkbaren Aktautorplatte 12_9' geschlossene Struktur ohne die Aussparung 42 aufweist. Die auslenkbare Aktuatorplatte 12_5' ist an einem äußeren Rand, d.h. einer äußeren Mantelfläche mittels der Anker 18_1a, 18_1b und 18_1c aufgehängt und weist den Kontaktbereich 38' auf, wie er in Fig. 10 für das MEMS 100 beschreiben ist. Die Anker 18-1a-c umschließen die äußere Mantelfläche und bedecken einen in Richtung der ersten Anschlagsfläche 14_11 weisenden Hauptseitenbereich der auslenkbaren Aktuatorplatte teilweise. An dem Kontaktbereich 38' ist die Elektrode 54 angeordnet, so dass ein elektrischer Kontakt zwischen der Elektrode 54 und der ersten Anschlagsfläche 14_11 herstellbar ist. Wie es durch eine gestrichelte Linie 74a und eine gestrichelte Linie 74b angedeutet ist, ist MEMS 130' in dem Zustand dargestellt, in dem die auslenkbare Aktuatorplatte 12_5' die Hohlwölbung ausführt. Die gestrichelten Linien 74a und 74 verlaufen entlang einer x-Richtung bzw. einer y-Richtung im Raum, wobei die x- und die y-Richtung senkrecht zueinander angeordnet sind. Der Kontaktbereich 38 kann bei einem Ausführen der Hohlwölbung in eine positive z-Richtung, die senkrecht zu der x- und der y-Richtung im Raum angeordnet ist, bewegt werden. Nimmt die auslenkbare Aktuatorplatte bspw. einen ebenen Zustand ein, so kann der Kontaktbereich 38 in eine negative z-Richtung bewegt werden.

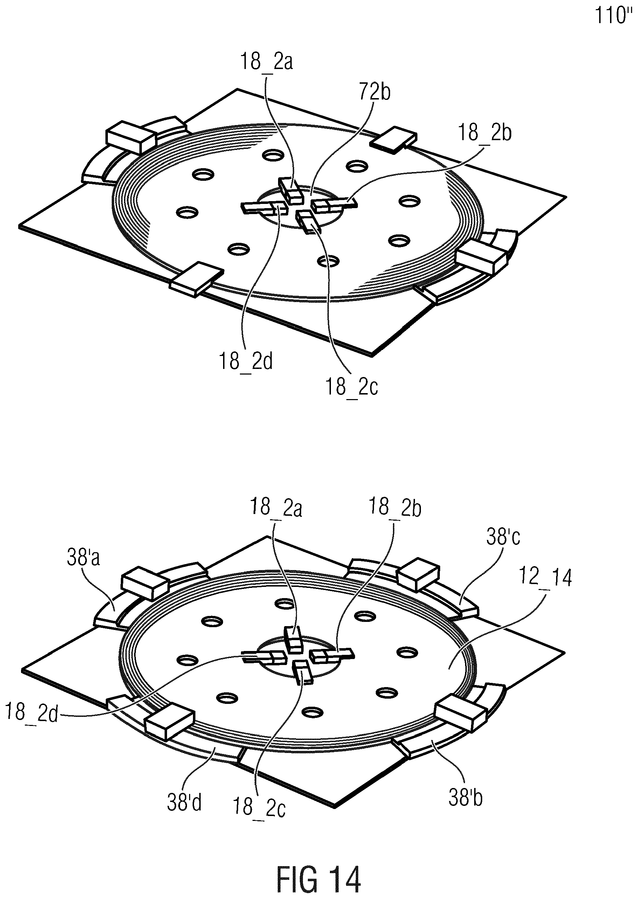

Fig. 14 zeigt in einem oberen Bildbereich eine schematische dreidimensionale Ansicht eines MEMS 110", das gegenüber dem MEMS 110' aus Fig. 11 die Anker 18_2a-d an der inneren Aussparung bzw. einer durch ein zentrales release hole 72 definierten inneren Mantelfläche aufweist.

In einem unteren Bildbereich zeigt Fig. 14 eine schematische dreidimensionale Ansicht eines MEMS 110"', das gegenüber dem MEMS 110' aus Fig. 11 zu den Kontaktbereichen 38'a und 38'b die zwei Kontaktbereiche 38'c und 38'd aufweist und lediglich über die Anker 18_2a-d, wie sie für das MEMS 110" beschrieben sind, aufgehängt ist. Die Kontaktbereiche 38'a-d sind beispielhaft äquidistant und paarweise gegenüberliegend an einer auslenkbaren Aktuatorplatte 12_14 angeordnet.

Wird ein MEMS gemäß der vorangegangenen Ausführungsbeispiele beispielsweise als ohmscher Schalter eingesetzt, kann die Anschlagsfläche in Kontaktpunkten, -linien oder - flächen die Anschlagsfläche selektiv aus leitfähigen Materialien bestehen oder diese aufweisen bzw. leitfähig beschichtet sein. Die entsprechenden Bereiche auf der auslenkbaren Aktuatorplatte können dann ebenfalls leitfähig bzw. leitfähig beschichtet sein. Auf diese Weise kann bei Betätigung des Aktuators in den Punkten der Berührung mit einer Anschlagsfläche ein Strompfad beispielsweise zwischen zwei leitfähigen Bereiche der entsprechenden Anschlagsfläche geschlossen werden. Diese Funktion kann der Funktion eines ohmschen Schalters, etwa eines Relais entsprechen.

Obwohl in vorangegangenen Ausführungsbeispielen die auslenkbare Aktuatorplatte stets basierend auf einem piezoelektrischen Effekt auslenkbar beschrieben wurde, sind auch andere Antriebsprinzipien vorstellbar, etwa eine thermische Aktuierung unter Ausnutzung verschiedener thermischer Ausdehnungskoeffizienten bei einer Temperaturänderung.

Die beschriebenen Aktuatorstrukturen können sich beispielsweise für Anwendungen, bei denen mittels piezoelektrischer Antriebe hohe Kräfte erzeugt werden sollen, eignen. Dies kann insbesondere auf MEMS-Schalter zutreffen, aber auch auf andere Anwendungsgebiete, wie beispielsweise mikromechanische Ventile, übertragen werden.

Die oben aufgeführten Ausführungsbeispiele zeigen auslenkbare Aktuatorplatten mit einer Hauptseitengeometrie, die entlang einer ersten Erstreckungsrichtung, bspw. entlang eines Durchmessers einer lateralen Erstreckung, wie etwa einer größten oder kleinsten Kantenlänge der Hauptseite oder einer Haupt- oder Nebenachse, etwa wenn die auslenkbare Aktuatorplatte eine elliptische Oberflächengeometrie aufweist, eine erste Abmessung aufweist. Entlang einer zweiten Erstreckungsrichtung, die senkrecht zu der ersten Erstreckungsrichtung entlang der Hauptseite angeordnet ist, weist die auslenkbare Aktuatorplatte eine zweite Abmessung auf. Die erste und die zweite Abmessung weisen ein Verhältnis mit einem Wert zwischen größer oder gleich 0,25 und kleiner oder gleich 4 auf. Alternative Ausführungsbeispiele weisen ein Verhältnis mit einem Wert von größer oder gleich 0,3 und kleiner oder gleich 3 oder größer oder gleich 0,35 und kleiner oder gleich 2,85 auf. In anderen Worten weist eine Aktuatorplatte eine gewisse Breite bezüglich einer Länge der Aktuatorplatte auf.

Obwohl manche Aspekte im Zusammenhang mit einer Vorrichtung beschrieben wurden, versteht es sich, dass diese Aspekte auch eine Beschreibung des entsprechenden Verfahrens darstellen, so dass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar.

Obwohl die Möglichkeit der elektrostatischen Klemmung lediglich im Zusammenhang mit MEMS 50 in Fig. 5 beschrieben wurde, versteht es sich, dass eine Anordnung einer Statorelektrode auch in anderen Ausführungsbeispielen angeordnet werden kann.

Obwohl die vorangegangenen Ausführungsbeispiele so beschrieben wurden, dass Anker an inneren oder äußeren Umfangs- oder Mantelflächen an einer jeweiligen auslenkbaren Aktuatorplatte angeordnet sind, können Anker auch in eine Hauptseite der jeweiligen auslenkbaren Aktuatorplatte hineinreichen, so dass die Mantelfläche von dem jeweiligen Anker zumindest teilweise umschlossen ist. Die auslenkbare Aktuatorplatte kann einstückig mit den Ankerelementen gebildet sein, so dass ein stetiger Materialübergang zwischen Anker und der auslenkbaren Aktuatorplatte existiert.

Obwohl in vorangegangenen Ausführungsbeispielen zwischen Anker(elementen) und Federelementen unterschieden wurde, versteht es sich, dass eine Wirkung der Federelemente, eine Federsteifigkeit, bei Ankerelementen ebenfalls vorhanden wenngleich ungleich größer ist. An Bereichen von Anschlagsflächen und/oder auslenkbaren Aktuatorplatten an denen in vorangegangenen Ausführungen die Anordnung eines Federelementes oder eines Ankers beschrieben wurde ist das jeweils andere Element, d. h. ein Anker oder ein Federelement, alternativ oder zusätzlich ebenfalls möglich.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

### Literatur

[1] Polcawich et al. "Surface Micromachined Microelectromechancial Ohmic Series Switch Using Thin-Film Piezoelectric Actuators", IEEE TRANSACTIONS ON MI-CROWAVE THEORY AND TECHNIQUES, VOL. 55, NO. 12, DECEMBER 2007
[2] Nakatani et al. "PZT-Actuated Reliable RF-MEMS Switch Using Single-Crystal Silicon Asymmetric Beam", Proceedings of the Asia-Pacific Microwave Conference 2011

## Patentansprüche

1. MEMS mit folgenden Merkmalen:
einer auslenkbaren Aktuatorplatte (12; 12_1-14; 12_2'; 12_5'; 12_9'; 12_10'-13'); und
einer Anschlagsfläche (14; 14_5-11);
wobei eine einstückige piezoelektrische Funktionsschicht (29) der auslenkbaren Aktuatorplatte (12; 12_1-14; 12_2'; 12_5'; 12_9'; 12_10'-13') über eine aktive Fläche (A_{PS}; A_{PS}_1; A_{PS}_2) der auslenkbaren Aktuatorplatte (12; 12_1-14; 12_2'; 12_5'; 12_9'; 12_10'-13') ausgebildet ist;
wobei die auslenkbare Aktuatorplatte (12; 12_1-14; 12_2'; 12_5'; 12_9'; 12_10'-13') einen angesteuerten Zustand (On-State) und einen nicht angesteuerten Zustand (Off-State) aufweist und in wenigstens einem der beiden Zustände eine Hohlwölbung ausführt;
wobei die Anschlagsfläche (14; 14_5-13; 14_9'-13') einer Hohlseite der auslenkbaren Aktuatorplatte (12; 12_1-14; 12_2'; 12_5'; 12_9'; 12_10'-13') zugewandt angeordnet ist;
wobei die auslenkbare Aktuatorplatte (12; 12_1-14; 12_2'; 12_5'; 12_9'; 12_10'-13') ausgebildet ist, um in dem Zustand, in welchem sie die Hohlwölbung ausführt, einen mechanischen Kontakt zwischen der auslenkbaren Aktuatorplatte (12; 12_1-14; 12_2'; 12_5'; 12_9'; 12_10'-13') und der Anschlagsfläche (14; 14_5-13; 14_9'-13') bereitzustellen;
wobei die auslenkbare Aktuatorplatte (12; 12_1-14; 12_2'; 12_5'; 12_9'; 12_10'-13') in dem anderen Zustand beabstandet zu der Anschlagsfläche (14; 14_5-13; 14_9'-13') ist;
**dadurch gekennzeichnet, dass** ein Ellipsenring (32; 32_1; 32_2; 32_3) existiert, der zu mehr als 95 % mit der aktiven Fläche (A_{PS}; A_{PS}_1; A_{PS}_2) überlappt, und dessen Ellipsenringfläche (A_{ER}; A_{ER}_1; A_{ER}_2) wenigstens 60 % einer Gesamtfläche (A_{AP}; A_{AP}_1; A_{AP}_2) der auslenkbaren Aktuatorplatte (12; 12_1-14; 12_2'; 12_5'; 12_9'; 12_10'-13') einnimmt;
wobei der Ellipsenring (32; 32_1; 32_2; 32_3) eine äußere Ellipsenbahn (44a) mit einer Hauptachse (34; 34_1; 34_4) und einer senkrecht zu der Hauptachse angeordneten Nebenachse (36; 36_1; 36_4) aufweist; und
wobei ein Verhältnis zwischen der Hauptachse (34; 34_1; 34_4) und der Nebenachse (36; 36_1; 36_4) einen Wert in einem Bereich von größer oder gleich 0,25 und kleiner oder gleich 4 aufweist.

2. MEMS gemäß Anspruch 1, bei dem die auslenkbare Aktuatorplatte (12; 12_1-14; 12_2'; 12_5'; 12_9'; 12_10'-13') eine Abmessung entlang einer ersten Erstreckungsrichtung und eine Abmessung entlang einer zweiten Erstreckungsrichtung aufweist, wobei die erste und die zweite Erstreckungsrichtung senkrecht zueinander entlang einer Hauptseite der auslenkbaren Aktuatorplatte (12; 12_1-14; 12_2'; 12_5'; 12_9'; 12_10'-13') angeordnet sind und wobei ein Verhältnis der beiden Abmessungen einen Wert in einem Bereich von größer oder gleich 0,25 und kleiner oder gleich 4 aufweist.

3. MEMS gemäß Anspruch 1 oder 2, das ferner eine weitere Anschlagsfläche (16; 16_5-12) aufweist, die der Anschlagsfläche (14; 14_5-13; 14_9'-13') gegenüberliegend angeordnet ist, wobei die auslenkbare Aktuatorplatte (12; 12_1-14; 12_2'; 12_5'; 12_9'; 12_10'-13') zwischen den Anschlagsflächen (14; 14_5-11; 14_10'; 14_12'; 16; 16_5-9) so aufgehängt ist, dass in dem Zustand, in dem die ansteuerbare Aktuatorplatte (12; 12_1-14; 12_2'; 12_5'; 12_9'; 12_10'-13') die Hohlwölbung ausführt, ein mechanischer Kontakt zwischen der ansteuerbaren Aktuatorplatte (12; 12_1-14; 12_2'; 12_5'; 12_9'; 12_10'-13') und der weiteren Anschlagsfläche (16; 16_5-12) bereitstellbar ist.

4. MEMS gemäß einem der vorangegangenen Ansprüche, bei dem die auslenkbare Aktuatorplatte (12; 12_1-14; 12_2'; 12_5'; 12_9'; 12_10'-13') in dem Zustand (Off-State), in der die auslenkbare Aktuatorplatte (12; 12_1-14; 12_2'; 12_5'; 12_9'; 12_10'-13') von der Anschlagsfläche (14; 14_5-13; 14_9'-13') beabstandet ist, eine Mehrzahl von Kontaktbereichen (38a-h; 38'1-b) aufweist, die auf einer kreisförmigen oder ellipsenförmigen Bahn angeordnet sind, wobei die Kontaktbereiche (38a-h; 38'1-b) ausgebildet sind, um mit der Anschlagsfläche (14; 14_5-13; 14_9'-13') den mechanischen Kontakt zu bilden.

5. MEMS gemäß einem der vorangegangenen Ansprüche, bei dem die Anschlagsfläche einen ersten Teilbereich (14_6a) und einen von dem ersten Teilbereich (14_6a) beabstandeten zweiten Teilbereich (14_6b) aufweist, wobei die auslenkbare Aktuatorplatte (12; 12_1-14; 12_2'; 12_5'; 12_9'; 12_10'-13') in dem Zustand, in dem sie die Hohlwölbung ausführt, ausgebildet ist, um den mechanischen Kontakt zwischen der auslenkbaren Aktuatorplatte (12; 12_1-14; 12_2'; 12_5'; 12_9'; 12_10'-13') und dem ersten Teilbereich (14_6a) und zwischen der auslenkbaren Aktuatorplatte (12; 12_1-14; 12_2'; 12_5'; 12_9'; 12_10'-13') und dem zweiten Teilbereich (14_6b) bereitzustellen.

6. MEMS gemäß einem der vorangegangenen Ansprüche, das ferner eine Elektrode (58) aufweist, die an der Anschlagsfläche (14; 14_5-13; 14_9'-13') oder an einer weiteren Anschlagsfläche (16; 16_5-12) angeordnet ist, so dass ein elektrisches Feld zwischen der Elektrode (58) und der auslenkbaren Aktuatorplatte (12; 12_1-14; 12_2'; 12_5'; 12_9'; 12_10'-13') erzeugbar ist, wobei die auslenkbare Aktuatorplatte (12; 12_1-14; 12_2'; 12_5'; 12_9'; 12_10'-13') ausgebildet ist, um basierend auf dem elektrostatischen Feld eine Bewegung in Richtung der Elektrode (58) auszuführen, wobei die weitere Anschlagsfläche (16; 16_5-12) der Anschlagsfläche (14; 14_5-13; 14_9'-13') gegenüberliegend angeordnet ist, so dass die auslenkbare Aktuatorplatte (12; 12_1-14; 12_2'; 12_5'; 12_9'; 12_10'-13') zwischen der Anschlagsfläche (14; 14_5-13; 14_9'-13') und der weiteren Anschlagsfläche (16; 16_5-12) angeordnet ist.

7. MEMS gemäß einem der vorangegangenen Ansprüche, bei dem die auslenkbare Aktuatorplatte (12; 12_1-14; 12_2'; 12_5'; 12_9'; 12_10'-13') ein Bimorph mit einem Substrat (24), einer ersten Elektrode (26a), die das Substrat (24) zumindest teilweise bedeckt, einem piezoelektrischen Material (28), die die erste Elektrode (26a) zumindest teilweise bedeckt und einer zweiten Elektrode (26b), die das piezoelektrische Material (28) zumindest teilweise bedeckt, ist.

8. MEMS gemäß einem der vorangegangenen Ansprüche, bei dem die auslenkbare Aktuatorplatte (12; 12_1-14; 12_2'; 12_5'; 12_9'; 12_10'-13') und die Anschlagsfläche (14; 14_5-13; 14_9'-13') jeweils in zumindest einem Kontaktbereich (38a-h; 38'1-b), in welchem der mechanische Kontakt zwischen der Anschlagsfläche (14; 14_5-13; 14_9'-13') und der auslenkbaren Aktuatorplatte (12; 12_1-14; 12_2'; 12_5'; 12_9'; 12_10'-13') bereitstellbar ist, Kontaktelektroden (54a-f) aufweisen.

9. MEMS gemäß Anspruch 8, bei dem der mechanische Kontakt in einem primären Kontaktbereich (38a; 38b) zu einem ersten Zeitpunkt bereitstellbar ist und bei dem die auslenkbare Aktuatorplatte (12; 12_1-14; 12_2'; 12_5'; 12_9'; 12_10'-13') und die Anschlagsfläche (14; 14_5-13; 14_9'-13') einen sekundären Kontaktbereich (38c; 38d) und daran angeordneten Elektroden aufweisen, wobei in dem Zustand, in dem die auslenkbare Aktuatorplatte (12; 12_1-14; 12_2'; 12_5'; 12_9'; 12_10'-13') die Hohlwölbung ausführt, ein elektrischer Kontakt zwischen der auslenkbaren Aktuatorplatte (12; 12_1-14; 12_2'; 12_5'; 12_9'; 12_10'-13') und der Anschlagsfläche (14; 14_5-13; 14_9'-13') in dem sekundären Kontaktbereich (38c; 38d) zu einem zweiten Zeitpunkt bereitstellbar ist, wobei der zweite Zeitpunkt auf den ersten Zeitpunkt folgt, wenn die mechanischen Kontakte in dem primären Kontaktbereich (38a; 38b) und dem sekundären Kontaktbereich (38c; 38d) bereitgestellt werden und wobei der erste Zeitpunkt auf den zweiten folgt, wenn die mechanischen Kontakte in dem primären Kontaktbereich (38a; 38b) und dem sekundären Kontaktbereich (38c; 38d) gelöst werden.

10. MEMS gemäß Anspruch 9 oder 10, das ferner eine weitere Anschlagsfläche (16; 16_5-12) aufweist, die der Anschlagsfläche (14; 14_5-13; 14_9'-13') gegenüberliegend angeordnet ist, wobei die auslenkbare Aktuatorplatte (12; 12_1-14; 12_2'; 12_5'; 12_9'; 12_10'-13') so zwischen den Anschlagsflächen (14; 14_5-11; 14_10'; 14_12'; 16; 16_5-9) aufgehängt ist, dass sie zumindest zu Kontaktzeiten, in denen der mechanische Kontakt zwischen der Anschlagsfläche (14; 14_5-13; 14_9'-13') und der auslenkbaren Aktuatorplatte (12; 12_1-14; 12_2'; 12_5'; 12_9'; 12_10'-13') bereitgestellt ist, elektrisch leitfähig mit der weiteren Anschlagsfläche (16; 16_5-12) kontaktiert ist, so dass die auslenkbare Aktuatorplatte (12; 12_1-14; 12_2'; 12_5'; 12_9'; 12_10'-13') ausgebildet ist, während den Kontaktzeiten eine elektrisch leitfähige Verbindung zwischen der Anschlagsfläche (14; 14_5-13; 14_9'-13') und der weiteren Anschlagsfläche (16; 16_5-12) herzustellen.

11. MEMS gemäß einem der Ansprüche 1-7, das ferner eine weitere Anschlagsfläche (16; 16_5-12) aufweist, die der Anschlagsfläche (14; 14_5-13; 14_9'-13') gegenüberliegend angeordnet ist und bei dem die Anschlagsfläche (14; 14_5-13; 14_9'-13') oder die weitere Anschlagsfläche (16; 16_5-12) einen Fluidzulauf (66) aufweist, der ausgebildet ist, um ein Fluid in ein Volumen zwischen die Anschlagsfläche (14; 14_5-13; 14_9'-13') und die weitere Anschlagsfläche (16; 16_5-12) passieren zu lassen und bei dem die Anschlagsfläche (14; 14_5-13; 14_9'-13') oder die weitere Anschlagsfläche (16; 16_5-12) einen Fluidablauf (66') aufweist, der ausgebildet ist, um das Fluid aus dem Volumen austreten zu lassen, wobei eine Menge eines Fluiddurchflusses (Q₁; Q₂) zwischen dem Fluiddurchfluss und dem Fluidabfluss basierend auf dem mechanischen Kontakt veränderlich ist.

12. MEMS gemäß einem der vorangegangenen Ansprüche, mit einer weiteren Anschlagsfläche (16; 16_5-12), die der ersten Anschlagsfläche (14; 14_5-13; 14_9'-13') gegenüberliegend angeordnet ist und bei dem die auslenkbare Aktuatorplatte (12; 12_1-14; 12_2'; 12_5'; 12_9'; 12_10'-13') mittels Ankerelementen (18_1a-d) an der weiteren Anschlagsfläche aufgehängt ist;
wobei die Ankerelemente (18_1a-d) äquidistant an einer äußeren Mantelfläche der auslenkbaren Aktuatorplatte (12; 12_1-14; 12_2'; 12_5'; 12_9'; 12_10'-13') angeordnet sind.

13. Elektrische Schaltung mit folgenden Merkmalen:
einem MEMS (10; 30; 40; 50; 60; 70; 90; 90'; 100; 100'; 110; 110') gemäß einem der Ansprüche 1-10; und
einer Steuereinheit, die mit dem MEMS gekoppelt ist und die ausgebildet ist, um die auslenkbare Aktuatorplatte (12; 12_1-14; 12_2'; 12_5'; 12_9'; 12_10'-13') anzusteuern.

14. Vorrichtung (80; 90) zum Transport eines Fluids mit folgenden Merkmalen:
einem MEMS gemäß Anspruch 11; und
einer Steuereinheit, die mit dem MEMS gekoppelt ist und die ausgebildet ist, um die auslenkbare Aktuatorplatte (12; 12_1-14; 12_2'; 12_5'; 12_9'; 12_10'-13') anzusteuern.

15. Verfahren zum Herstellen eines Mikro-Elektro-Mechanischen System (MEMS) mit folgenden Schritten:
Bereitstellen einer auslenkbaren Aktuatorplatte (12; 12_1-14; 12_2'; 12_5'; 12_9'; 12_10'-13') mit einer einstückigen piezoelektrischen Funktionsschicht (29), die über eine aktive Fläche (A_{PS}; A_{PS}_1; A_{PS}_2) der auslenkbaren Aktuatorplatte (12; 12_1-14; 12_2'; 12_5'; 12_9'; 12_10'-13') ausgebildet ist; und
Bereitstellen einer Anschlagsfläche (14; 14_5-13; 14_9'-13');
wobei das Bereitstellen der Aktuatorplatte so ausgeführt wird, dass
die auslenkbare Aktuatorplatte (12; 12_1-14; 12_2'; 12_5'; 12_9'; 12_10'-13') einen angesteuerten Zustand (On-State) und einen nicht angesteuerten Zustand (Off-State) aufweist und in wenigstens einem der beiden Zustände eine Hohlwölbung ausführt und
die Anschlagsfläche (14; 14 5-13; 14_9'-13') einer Hohlseite der auslenkbaren Aktuatorplatte (12; 12_1-14; 12_2'; 12_5'; 12_9'; 12_10'-13') zugewandt angeordnet ist und
die auslenkbare Aktuatorplatte (12; 12_1-14; 12_2'; 12_5'; 12_9'; 12_10'-13') ausgebildet ist, um in dem Zustand, in welchem sie die Hohlwölbung ausführt, einen mechanischen Kontakt zwischen der auslenkbaren Aktuatorplatte (12; 12_1-14; 12_2'; 12_5'; 12_9'; 12_10'-13') und der Anschlagsfläche (14; 14_5-13; 14_9'-13') bereitzustellen und
die auslenkbare Aktuatorplatte (12; 12_1-14; 12_2'; 12_5'; 12_9'; 12_10'-13') in dem anderen Zustand beabstandet zu der Anschlagsfläche (14; 14_5-13; 14_9'-13') ist;
**dadurch gekennzeichnet, dass** das Bereitstellen der Aktuatorplatte so ausgeführt wird, dass ein Ellipsenring (32; 32_1; 32_2; 32_3) existiert, der zu mehr als 95 % mit der aktiven Fläche (A_{PS}; A_{PS}_1; A_{PS}_2) überlappt, und dessen Ellipsenringfläche (A_{ER}; A_{ER}_1; A_{ER}_2) wenigstens 60 % einer Gesamtfläche (A_{AP}; A_{AP}_1; A_{AP}_2) der auslenkbaren Aktuatorplatte (12; 12_1-14; 12_2'; 12_5'; 12_9'; 12_10'-13') einnimmt;
so dass der Ellipsenring (32; 32_1; 32_2; 32_3) eine äußere Ellipsenbahn (44a) mit einer Hauptachse (34; 34_1; 34_4) und einer senkrecht zu der Hauptachse angeordneten Nebenachse (36; 36_1; 36_4) aufweist; und
so dass ein Verhältnis zwischen der Hauptachse (34; 34_1; 34_4) und der Nebenachse (36; 36_1; 36_4) einen Wert in einem Bereich von größer oder gleich 0,25 und kleiner oder gleich 4 aufweist.

## Claims

1. An MEMS comprising:
a deflectable actuator plate (12; 12_1-14; 12_2'; 12_5'; 12_9'; 12_10'-13'); and
an abutment area (14; 14_5-11);
wherein an integral piezoelectric functional layer (29) of the deflectable actuator plate (12; 12_1-14; 12_2'; 12_5'; 12_9'; 12_10'-13') is configured across an active area (A_{PS}; A_{PS}_1; A_{PS}_2) of the deflectable actuator plate (12; 12_1-14; 12_2'; 12_5'; 12_9'; 12_10'-13');
wherein the deflectable actuator plate (12; 12_1-14; 12_2'; 12_5'; 12_9'; 12_10'-13') comprises a controlled state (on-state) and a non-controlled state (off-state) and effects a hollow warp in at least one of the two states;
wherein the abutment area (14; 14_5-13; 14_9'-13') of a hollow side is disposed facing a hollow side of the deflectable actuator plate (12; 12_1-14; 12_2'; 12_5'; 12_9'; 12_10'-13');
wherein the deflectable actuator plate (12; 12_1-14; 12_2'; 12_5'; 12_9'; 12_10'-13') is configured to provide in the state in which the same effects the hollow warp, mechanical contact between the deflectable actuator plate (12; 12_1-14; 12_2'; 12_5'; 12_9'; 12_10'-13') and the abutment area (14; 14_5-13; 14_9'-13'); and
wherein the deflectable actuator plate (12; 12_1-14; 12_2'; 12_5'; 12_9'; 12_10'-13') is spaced apart from the abutment area (14; 14_5-13; 14_9'-13') in the other state;
**characterized in that**:
an elliptical ring (32; 32_1; 32_2; 32_3) exists, which overlaps by more than 95% with the active area (A_{PS}; A_{PS}_1; A_{PS}_2) and whose elliptical ring area (A_{ER}; A_{ER}_1; A_{ER}_2) takes up at least 60 % of an overall area (A_{AP}; A_{AP}_1; A_{AP}_2) of the deflectable actuator plate (12; 12_1-14; 12_2'; 12_5'; 12_9'; 12_10'-13');
wherein the elliptical ring (32; 32_1; 32_2; 32_3) comprises an outer elliptical trajectory (44a) with a main axis (34; 34_1; 34_4) and a minor axis (36; 36_1; 36_4) disposed perpendicularly to the main axis; and
wherein a ratio between the main axis (34; 34_1; 34_4) and the minor axis (36; 36_1; 36_4) comprises a value in the range of greater than or equal to 0.25 and less than or equal to 4.

2. The MEMS according to claim 1, wherein the deflectable actuator plate (12; 12_1-14; 12_2'; 12_5'; 12_9'; 12_10'-13') comprises a dimension along a first direction of extension and a dimension along a second direction of extension, wherein the first and second directions of extension are disposed perpendicularly to one another along a main side of the deflectable actuator plate (12; 12_1-14; 12_2'; 12_5'; 12_9'; 12_10'-13') and wherein a ratio of the two dimensions comprises a value in a range of greater than or equal to 0.25 and less than or equal to 4.

3. The MEMS according to claims 1 or 2, further comprising a further abutment area (16; 16_5-12) disposed opposite to the abutment area (14; 14_5-13; 14_9'-13'), wherein the deflectable actuator plate (12; 12_1-14; 12_2'; 12_5'; 12_9'; 12_10'-13') is suspended between the abutment areas (14; 14_5-11; 14_10'; 14_12'; 16; 16_5-9) such that in the state in which the controllable actuator plate (12; 12_1-14; 12_2'; 12_5'; 12_9'; 12_10'-13') effects the hollow warp, a mechanical contact can be provided between the controllable actuator plate (12; 12_1-14; 12_2'; 12_5'; 12_9'; 12_10'-13') and the further abutment area (16; 16_5-12).

4. The MEMS according to any of the previous claims, wherein the deflectable actuator plate (12; 12_1-14; 12_2'; 12_5'; 12_9'; 12_10'-13') comprises, in the state (off-state) where the deflectable actuator plate (12; 12_1-14; 12_2'; 12_5'; 12_9'; 12_10'-13') is spaced apart from the abutment area (14; 14_5-13; 14_9'-13'), a plurality of contact areas (38a-h; 38'1-b) which are disposed on a circular or elliptical trajectory, wherein the contact areas (38a-h; 38'1-b) are configured to establish the mechanical contact with the abutment area (14; 14_5-13; 14_9'-13').

5. The MEMS according to any of the previous claims, wherein the abutment area comprises a first subregion (14_6a) and a second subregion (14_6b) spaced apart from the first subregion (14_6a), wherein the deflectable actuator plate (12; 12_1-14; 12_2'; 12_5'; 12_9'; 12_10'-13') is implemented, in the state where the same effects the hollow warp, to provide the mechanical contact between the deflectable actuator plate (12; 12_1-14; 12_2'; 12_5'; 12_9'; 12_10'-13') and the first subregion (14_6a) and between the deflectable actuator plate (12; 12_1-14; 12_2'; 12_5'; 12_9'; 12_10'-13') and the second subregion (14_6b).

6. The MEMS according to any of the previous claims, further comprising an electrode (58) disposed on the abutment area (14; 14_5-13; 14_9'-13') or on a further abutment area (16; 16_5-12) such that an electric field can be generated between the electrode (58) and the deflectable actuator plate (12; 12_1-14; 12_2'; 12_5'; 12_9'; 12_10'-13'), wherein the deflectable actuator plate (12; 12_1-14; 12_2'; 12_5'; 12_9'; 12_10'-13') is configured to effect, based on the electrostatic field, a movement in the direction of the electrode (58), wherein the further abutment area (16; 16_5-12) is disposed opposite to the abutment area (14; 14_5-13; 14_9'-13') such that the deflectable actuator plate (12; 12_1-14; 12_2'; 12_5'; 12_9'; 12_10'-13') is disposed between the abutment area (14; 14_5-13; 14_9'-13') and the further abutment area (16; 16_5-12).

7. The MEMS according to any of the previous claims, wherein the deflectable actuator plate (12; 12_1-14; 12_2'; 12_5'; 12_9'; 12_10'-13') is a bimorph comprising a substrate (24), a first electrode (26a) that covers the substrate (24) at least partly, piezoelectric material (28) that covers the first electrode (26a) at least partly, and a second electrode (26b) that covers the piezoelectric material (28) at least partly.

8. The MEMS according to any of the previous claims, wherein the deflectable actuator plate (12; 12_1-14; 12_2'; 12_5'; 12_9'; 12_10'-13') and the abutment area (14; 14_5-13; 14_9'-13') each comprise contact electrodes (54a-f) in at least one contact area (38a-h; 38'1-b) in which the mechanical contact can be provided between the abutment area (14; 14_5-13; 14_9'-13') and the deflectable actuator plate (12; 12_1-14; 12_2'; 12_5'; 12_9'; 12_10'-13').

9. The MEMS according to claim 8, wherein the mechanical contact can be provided at a first time in a primary contact area (38a; 38b) and wherein the deflectable actuator plate (12; 12_1-14; 12_2'; 12_5'; 12_9'; 12_10'-13') and the abutment area (14; 14_5-13; 14_9'-13') comprise a secondary contact area (38c; 38d) and electrodes disposed thereon, wherein in the state, in which the deflectable actuator plate (12; 12_1-14; 12_2'; 12_5'; 12_9'; 12_10'-13') effects the hollow warp, an electrical contact can be provided between the deflectable actuator plate (12; 12_1-14; 12_2'; 12_5'; 12_9'; 12_10'-13') and the abutment area (14; 14_5-13; 14_9'-13') in the secondary contact area (38c; 38d) at the second time, wherein the second time follows the first time when the mechanical contacts are provided in the primary contact area (38a; 38b) and the secondary contact area (38c; 38d), and wherein the first time follows the second time when the mechanical contacts are released in the primary contact area (38a; 38b) and the secondary contact area (38c; 38d).

10. The MEMS according to claims 9 or 10, further comprising a further abutment area (16; 16_5-12) disposed opposite to the abutment area (14; 14_5-13; 14_9'-13'), wherein the deflectable actuator plate (12; 12_1-14; 12_2'; 12_5'; 12_9'; 12_10'-13') is suspended between the abutment areas (14; 14_5-11; 14_10'; 14_12'; 16; 16_5-9) such that the same is in electrically conductive contact with the further abutment area (16; 16_5-12), at least at contact times where the mechanical contact between the abutment area (14; 14_5-13; 14_9'-13') and deflectable actuator plate (12; 12_1-14; 12_2'; 12_5'; 12_9'; 12_10'-13') is provided such that the deflectable actuator plate (12; 12_1-14; 12_2'; 12_5'; 12_9'; 12_10'-13') is configured to establish an electrically conductive connection between the abutment area (14; 14_5-13; 14_9'-13') and the further abutment area (16; 16_5-12) during the contact times.

11. The MEMS according to any of claims 1 to 11, further comprising a further abutment area (16; 16_5-12) which is disposed opposite to the abutment area (14; 14_5-13; 14_9'-13'), and wherein the abutment area (14; 14_5-13; 14_9'-13') or the further abutment area (16; 16_5-12) comprises a fluid inlet (66) which is configured to let a fluid pass into a volume between the abutment area (14; 14_5-13; 14_9'-13') and the further abutment area (16; 16_5-12) and wherein the abutment area (14; 14_5-13; 14_9'-13') or the further abutment area (16; 16_5-12) comprises a fluid outlet (66') that is configured to let the fluid exit from the volume, wherein an amount of a fluid flow (Q₁; Q₂) between the fluid inlet and the fluid outlet is variable based on the mechanical contact.

12. The MEMS according to any of the previous claims, comprising a further abutment area (16; 16_5-12) which is disposed opposite to the first abutment area (14; 14_5-13; 14_9'-13') and wherein the deflectable actuator plate (12; 12_1-14; 12_2'; 12_5'; 12_9'; 12_10'-13') is suspended on the further abutment area by means of anchor elements (18_1a-d);
wherein the anchor elements (18_1a-d) are disposed equidistantly on an outer cladding area of the deflectable actuator plate (12; 12_1-14; 12_2'; 12_5'; 12_9'; 12_10'-13').

13. An electrical circuit, comprising:
an MEMS (10; 30; 40; 50; 60; 70; 90; 90'; 100; 100'; 110; 110') according to any of claims 1 to 10; and
a control unit coupled to the MEMS and configured to control the deflectable actuator plate (12; 12_1-14; 12_2'; 12_5'; 12_9'; 12_10'-13').

14. An apparatus (80; 90) for transporting a fluid, comprising:
an MEMS according to claim 11; and
a control unit coupled to the MEMS and configured to control the deflectable actuator plate (12; 12_1-14; 12_2'; 12_5'; 12_9'; 12_10'-13').

15. A method for producing a micro-electro-mechanical system (MEMS) comprising:
providing a deflectable actuator plate (12; 12_1-14; 12_2'; 12_5'; 12_9'; 12_10'-13') with an integral piezoelectric functional layer (29) which is configured across an active area (A_{PS}; A_{PS}_1; A_{PS}_2) of the deflectable actuator plate (12; 12_1-14; 12_2'; 12_5'; 12_9'; 12_10'-13'); and
providing an abutment area (14; 14_5-13; 14_9'-13');
wherein providing the deflectable actuator plate is effected such that:
the deflectable actuator plate (12; 12_1-14; 12_2'; 12_5'; 12_9'; 12_10'-13') comprises a controlled state (on-state) and a non-controlled state (off-state) and effects a hollow warp in at least one of the two states and
the abutment area (14; 14_5-13; 14_9'-13') is disposed facing a hollow side of the deflectable actuator plate (12; 12_1-14; 12_2'; 12_5'; 12_9'; 12_10'-13') and
the deflectable actuator plate (12; 12_1-14; 12_2'; 12_5'; 12_9'; 12_10'-13') is configured to provide in the state in which the same effects the hollow warp, mechanical contact between the deflectable actuator plate (12; 12_1-14; 12_2'; 12_5'; 12_9'; 12_10'-13') and the abutment area (14; 14_5-13; 14_9'-13') and
the deflectable actuator plate (12; 12_1-14; 12_2'; 12_5'; 12_9'; 12_10'-13') is spaced apart from the abutment area (14; 14_5-13; 14_9'-13') in the other state;
**characterized in that**:
providing the actuator plate is effected such that an elliptical ring (32; 32_1; 32_2; 32_3) exists, which overlaps by more than 95% with the active area (A_{PS}; A_{PS}_1; A_{PS}_2) and whose elliptical ring area (A_{ER}; A_{ER}_1; A_{ER}_2) takes up at least 60 % of an overall area (A_{AP}; A_{AP}_1; A_{AP}_2) of the deflectable actuator plate (12; 12_1-14; 12_2'; 12_5'; 12_9'; 12_10'-13');
such that the elliptical ring (32; 32_1; 32_2; 32_3) comprises an outer elliptical trajectory (44a) with a main axis (34; 34_1; 34_4) and a minor axis (36; 36_1; 36_4) disposed perpendicularly to the main axis; and
such that a ratio between the main axis (34; 34_1; 34_4) and the minor axis (36; 36_1; 36_4) comprises a value in the range of greater than or equal to 0.25 and less than or equal to 4.

## Revendications

1. MEMS, aux caractéristiques suivantes:
une plaque d'actionneur déformable (12; 12_1 à 14; 12_2'; 12_5'; 12_9'; 12_10' à 13'); et
une surface de butée (14; 14_5 à 11);
dans lequel une couche fonctionnelle piézoélectrique d'une seule pièce (29) de la plaque d'actionneur déformable (12; 12_1 à 14; 12_2'; 12_5'; 12_9'; 12_10' à 13') est réalisée sur une surface active (A_{PS}; A_{PS}_1; A_{PS}_2) de la plaque d'actionneur déformable (12; 12_1 à 14; 12_2'; 12_5'; 12_9'; 12_10'à 13');
dans lequel la plaque d'actionneur déformable (12; 12_1 à 14; 12_2'; 12_5'; 12_9'; 12_10' à 13') présente un état activé (état ON) et un état non activé (état OFF) et réalise une concavité dans au moins l'un de deux états;
dans lequel la surface de butée (14; 14_5 à 13; 14_9' à 13') est disposée de manière orientée vers un côté creux de la plaque d'actionneur déformable (12; 12_1 à 14; 12_2'; 12_5'; 12_9'; 12_10' à 13');
dans lequel la plaque d'actionneur déformable (12; 12_1 à 14; 12_2'; 12_5'; 12_9'; 12_10' à 13') est conçue, à l'état dans lequel elle réalise la concavité, pour établir un contact mécanique entre la plaque d'actionneur déformable (12; 12_1 à 14; 12_2'; 12_5'; 12_9'; 12_10' à 13') et la surface de butée (14; 14_5 à 13; 14_9' à 13');
dans lequel la plaque d'actionneur déformable (12; 12_1 à 14; 12_2'; 12_5'; 12_9'; 12_10' à 13') est, dans l'autre état, distante de la surface de butée (14; 14_5 à 13; 14_9' à 13');
**caractérisé par le fait qu'**il existe une bague elliptique (32; 32_1; 32_2; 32_3) qui vient de plus de 95% en recouvrement avec la surface active (A_{PS}; A_{PS}_1; A_{PS}_2) et dont la surface de bague elliptique (A_{ER}; A_{ER}_1; A_{ER}_2) occupe au moins 60% d'une surface totale (A_{AP}; A_{AP}_1; A_{AP}_2) de la plaque d'actionneur déformable (12; 12_1 à 14; 12_2'; 12_5'; 12_9'; 12_10'à 13');
dans lequel la bague elliptique (32; 32_1; 32_2; 32_3) présente un trajet elliptique extérieur (44a) avec un axe principal (34; 34_1; 34_4) et un axe secondaire (36; 36_1; 36_4) disposé de manière perpendiculaire à l'axe principal; et
dans lequel un rapport entre l'axe principal (34; 34_1; 34_4) et l'axe secondaire (36; 36_1; 36_4) présente une valeur dans une plage supérieure ou égale à 0,25 et inférieure ou égale à 4.

2. MEMS selon la revendication 1, dans lequel la plaque d'actionneur déformable (12; 12_1 à 14; 12_2'; 12_5'; 12_9'; 12_10' à 13') présente une dimension dans une première direction d'extension et une dimension dans une deuxième direction d'extension, où les première et deuxième directions d'extension sont disposées de manière perpendiculaire l'une à l'autre le long d'un côté principal de la plaque d'actionneur déformable (12; 12_1 à 14; 12_2'; 12_5'; 12_9'; 12_10' à 13') et dans lequel un rapport entre les deux dimensions présente une valeur dans une plage supérieure ou égale à 0,25 et inférieure ou égale à 4.

3. MEMS selon la revendication 1 ou 2, présentant par ailleurs une autre surface de butée (16; 16_5 à 12) disposée opposée à la surface de butée (14; 14_5 à 13; 14_9' à 13'), dans lequel la plaque d'actionneur déformable (12; 12_1 à 14; 12_2'; 12_5'; 12_9'; 12_10' à 13') est suspendue entre les surfaces de butée (14; 14_5 à 11; 14_10'; 14_12'; 16; 16_5 à 9) de sorte que, à l'état dans lequel la plaque d'actionneur pouvant être activée (12; 12_1 à 14; 12_2'; 12_5'; 12_9'; 12_10' à 13') réalise la concavité, puisse être réalisé un contact mécanique entre la plaque d'actionneur activable (12; 12_1 à 14; 12_2'; 12_5' 12_9'; 12_10' à 13') et l'autre surface de butée (16; 16_5 à 12).

4. MEMS selon l'une des revendications précédentes, dans lequel la plaque d'actionneur déformable (12; 12_1 à 14; 12_2'; 12_5'; 12_9'; 12_10' à 13') présente, à l'état (état OFF) dans lequel la plaque d'actionneur déformable (12; 12_1 à 14; 12_2'; 12_5'; 12_9'; 12_10' à 13') est distante de la surface de butée (14; 14_5 à 13; 14_9' à 13'), une pluralité de zones de contact (38a à h; 38'1 à b) qui sont disposées sur un chemin circulaire ou elliptique, où les zones de contact (38a à h; 38'1 à b) sont conçues pour établir le contact mécanique avec la surface de butée (14; 14_5 à 13; 14_9' à 13').

5. MEMS selon l'une des revendications précédentes, dans lequel la surface de butée présente une première zone partielle (14_6a) et une deuxième région partielle (14_6b) distante de la première zone partielle (14_6a), dans lequel la plaque d'actionnement déformable (12; 12_1 à 14; 12_2'; 12_5'; 12_9'; 12_10' à 13') est conçue, à l'état dans lequel elle réalise la concavité, pour établir le contact mécanique entre la plaque d'actionneur déformable (12; 12_1 à 14; 12_2'; 12_5'; 12_9'; 12_10' à 13') et la première zone partielle (14_6a) et entre la plaque d'actionneur déformable (12; 12_1 à 14; 12_2'; 12_5'; 12_9'; 12_10' à 13') et la deuxième zone partielle (14_6b).

6. MEMS selon l'une des revendications précédentes, présentant par ailleurs une électrode (58) qui est disposée sur la surface de butée (14; 14_5 à 13; 14_9' à 13') ou sur une autre surface de butée (16; 16_5 à 12), de sorte qu'un champ électrique puisse être généré entre l'électrode (58) et la plaque d'actionneur déformable (12; 12_1 à 14; 12_2'; 12_5'; 12_9'; 12_10' à 13'), dans lequel la plaque d'actionneur déformable (12; 12_1 à 14; 12_2'; 12_5'; 12_9'; 12_10' à 13') est conçue pour réaliser, sur base du champ électrostatique, un déplacement en direction de l'électrode (58), où l'autre surface de butée (16; 16_5 à 12) est disposée opposée à la surface de butée (14; 14_5 à 13; 14_9' à 13'), de sorte que la plaque d'actionneur déformable (12; 12_1 à 14; 12_2'; 12_5'; 12_9'; 12_10' à 13') soit disposée entre la surface de butée (14; 14_5 à 13; 14_9' à 13') et l'autre surface de butée (16; 16_5 à 12).

7. MEMS selon l'une des revendications précédentes, dans lequel la plaque d'actionneur déformable (12; 12_1 à 14; 12_2'; 12_5'; 12_9'; 12_10' à 13') est un élément bimorphe avec un substrat (24), une première électrode (26a) qui recouvre au moins partiellement le substrat (24), un matériau piézoélectrique (28) qui recouvre au moins partiellement la première électrode (26a) et une deuxième électrode (26b) qui recouvre au moins partiellement le matériau piézoélectrique (28).

8. MEMS selon l'une des revendications précédentes, dans lequel la plaque d'actionneur déformable (12; 12_1 à 14; 12_2'; 12_5'; 12_9'; 12_10' à 13') et la surface de butée (14; 14_5 à 13; 14_9' à 13') présentent chacune des électrodes de contact (54a à f) dans au moins une zone de contact (38a à h; 38'1 à b) dans laquelle peut être établi le contact mécanique entre la surface de butée (14; 14_5 à 13; 14_9' à 13') et la plaque d'actionneur déformable (12; 12_1 à 14; 12_2'; 12_5'; 12_9' 12_10' à 13').

9. MEMS selon la revendication 8, dans lequel le contact mécanique dans une zone de contact primaire (38a; 38b) peut être établi à un premier moment et dans lequel la plaque d'actionneur déformable (12; 12_1 à 14; 12_2'; 12_5'; 12_9'; 12_10' à 13') et la surface de butée (14; 14_5 à 13; 14_9' à 13') présentent une zone de contact secondaire (38c; 38d) et des électrodes disposées sur cette dernière, dans lequel, à l'état dans lequel la plaque d'actionneur déformable (12; 12_1 à 14; 12_2'; 12_5'; 12_9'; 12_10' à 13') réalise la concavité, un contact électrique entre la plaque d'actionneur déformable (12; 12_1 à 14; 12_2'; 12_5'; 12_9'; 12_10' à 13') et la surface de butée (14; 14_5 à 13; 14_9' à 13') peut être établi dans la zone de contact secondaire (38c; 38d) à un deuxième moment, le deuxième moment suivant le premier moment lorsque les contacts mécaniques sont établis dans la zone de contact primaire (38a; 38b) et la zone de contact secondaire (38c; 38d) et le premier moment suivant le deuxième moment lorsque les contacts mécaniques dans la zone de contact primaire (38a; 38b) et dans la zone de contact secondaire (38c, 38d) sont éliminés.

10. MEMS selon la revendication 9 ou 10, présentant par ailleurs une autre surface de butée (16; 16_5 à 12) qui est disposée opposée à la surface de butée (14; 14_5 à 13; 14_9' à 13'), dans lequel la plaque d'actionneur déformable (12; 12_1 à 14; 12_2'; 12_5' 12_9'; 12_10' à 13') est suspendue entre les surfaces de butée (14; 14_5 à 11; 14_10'; 14_2'; 16; 16_5 à 9) de sorte qu'elles soient, au moins à des moments de contact où le contact mécanique est établi entre la surface de butée (14; 14_5 à 13; 14_9' à 13') et la plaque d'actionneur déformable (12; 12_1 à 14; 12_2'; 12_5'; 12_9'; 12_10' à 13'), en contact de manière électriquement conductrice avec l'autre surface de butée (16; 16_5 à 12), de sorte que la plaque d'actionneur déformable (12; 12_1 à 14; 12_2'; 12_5'; 12_9'; 12_10' à 13') soit conçue pour réaliser, pendant les moments de contact, une connexion électriquement conductrice entre la surface de butée (14; 14_5 à 13; 14_9' à 13') et l'autre surface de butée (16; 16_5 à 12).

11. MEMS selon l'une des revendications 1 à 7, présentant par ailleurs une autre surface de butée (16; 16_5 à 12) qui est disposée opposée à la surface de butée (14; 14_5 à 13; 14_9' à 13') et dans lequel la surface de butée (14; 14_5 à 13; 14_9' à 13') ou l'autre surface de butée (16; 16_5 à 12) présente un conduit d'amenée de fluide (66) qui est conçu pour laisser passer un fluide dans un volume entre la surface de butée (14; 14_5 à 13; 14_9' à 13') et l'autre surface de butée (16; 16_5 à 12), et dans lequel la surface de butée (14; 14_5 à 13; 14_9' à 13') ou l'autre surface de butée (16; 16_5 à 12) présente un conduit d'évacuation de fluide (66') qui est conçu pour laisser sortir le fluide du volume, où une quantité de passage de fluide (Q₁; Q₂) entre le passage de fluide et l'évacuation de fluide est variable sur base du contact mécanique.

12. MEMS selon l'une des revendications précédentes, avec une autre surface de butée (16; 16_5 à 12) qui est disposée opposée à la première surface de butée (14; 14_5 à 13; 14_9' à 13') et dans lequel la plaque d'actionneur déformable (12; 12_1 à 14; 12_2'; 12_5'; 12_9'; 12_10' à 13') est suspendue au moyen d'éléments d'ancrage (18_1a à d) à l'autre surface de butée;
dans lequel les éléments d'ancrage (18_1a à d) sont disposés de manière équidistante sur une surface enveloppante extérieure de la plaque d'actionneur déformable (12; 12_1 à 14; 12_2'; 12_5'; 12_9'; 12_10' à 13').

13. Circuit électrique aux caractéristiques suivantes:
un MEMS (10; 30; 40; 50; 60; 70; 90; 90'; 100; 100'; 110; 110') selon l'une des revendications 1 à 10; et
une unité de commande qui est couplée au MEMS et qui est conçue pour activer la plaque d'actionneur déformable (12; 12_1 à 14; 12_2'; 12_5'; 12_9'; 12_10' à 13').

14. Dispositif (80; 90) pour transporter un fluide, aux caractéristiques suivantes:
un MEMS selon la revendication 11; et
une unité de commande qui est couplée au MEMS et qui est conçue pour activer la plaque d'actionneur déformable (12; 12_1 à 14; 12_2'; 12_5'; 12_9'; 12_10' à 13').

15. Procédé de fabrication d'un système micro-électro-mécanique (MEMS), aux étapes suivantes consistant à:
prévoir une plaque d'actionneur déformable (12; 12_1 à 14; 12_2'; 12_5'; 12_9'; 12_10' à 13') avec une couche fonctionnelle piézoélectrique d'une seule pièce (29) qui est réalisée sur une surface active (A_{PS}; A_{PS}_1; A_{PS}_2) de la plaque d'actionneur déformable (12; 12_1 à 14; 12_2'; 12_5'; 12_9'; 12_10' à 13'); et
prévoir une surface de butée (14; 14_5 à 13; 14_9' à 13')
dans lequel la prévision de la plaque d'actionneur est réalisée de sorte que
la plaque d'actionneur déformable (12; 12_1 à 14; 12_2'; 12_5'; 12_9'; 12_10' à 13') présente un état activé (état ON) et un état non activé (état OFF) et réalise une concavité dans au moins l'un des deux états, et
la surface de butée (14; 14_5 à 13; 14_9' à 13') est disposée de manière orientée vers un côté creux de la plaque d'actionneur déformable (12; 12_1 à 14; 12_2'; 12_5'; 12_9'; 12_10' à 13'), et
la plaque d'actionneur déformable (12; 12_1 à 14; 12_2'; 12_5'; 12_9'; 12_10' à 13') est conçue pour établir, à l'état dans lequel elle réalise la concavité, un contact mécanique entre la plaque d'actionneur déformable (12; 12_1 à 14; 12_2'; 12_5'; 12_9'; 12_10' à 13') et la surface de butée (14; 14_5 à 13; 14_9' à 13'), et
la plaque d'actionneur déformable (12; 12_1 à 14; 12_2'; 12_5'; 12_9'; 12_10' à 13') est, dans l'autre état, distante de la surface de butée (14; 14_5 à 13; 14_9' à 13');
**caractérisé par le fait que**
la prévision de la plaque d'actionneur est réalisée de sorte qu'il existe une bague elliptique (32; 32_1; 32_2; 32_3) qui vient de plus de 95% en recouvrement avec la surface active (Aps; A_{PS}_1; A_{PS}_2) et dont la surface de bague elliptique (A_{ER}; A_{ER}_1; A_{ER}_2) occupe au moins 60% d'une surface totale (A_{AP}; A_{AP}_1; A_{AP}_2) de la plaque d'actionneur déformable (12; 12_1 à 14; 12_2'; 12_5'; 12_9'; 12_10' à 13');
que la bague elliptique (32; 32_1; 32_2; 32_3) présente un trajet elliptique extérieur (44a) avec un axe principal (34; 34_1; 34_4) et un axe secondaire (36; 36_1; 36_4) disposé de manière perpendiculaire à l'axe principal; et
qu' un rapport entre l'axe principal (34; 34_1; 34_4) et l'axe secondaire (36; 36_1; 36_4) présente une valeur dans une plage supérieure ou égale à 0,25 et inférieure ou égale à 4.
